# EUROPEAN PATENT APPLICATION

(11) **EP 3 608 017 A1**
(43) Date of publication of application: **12.02.2020**
(21) Application number: 18780693.0
(22) Date of filing: 02.04.2018
(51) Int. Cl.: B01J 19/00, B81B 1/00, F28F 3/08

(54) **FLUID FLOW-PASSAGE DEVICE**

(30) Priority: 06.04.2017 JP 2017076032
(71) Applicant: Kabushiki Kaisha Kobe Seiko Sho (Kobe Steel, Ltd.), Kobe-shi, Hyogo 651-8585 (JP)
(72) Inventor: OZONO, Tomohiro, Hyogo 676-8670 (JP); YAGI, Yutaka, Hyogo 676-8670 (JP); NOISHIKI, Koji, Hyogo 676-8670 (JP)
(74) Representative: TBK
(86) International application number: PCT/JP2018/014107
(87) International publication number: WO 2018/186347

(57) **Abstract**

Provided is a fluid flow-passage device in which the flow passage length of each of a plurality of fluid flow-passages can be increased even if the plurality of fluid flow-passages are formed so as to extend in parallel to each other, and in which the inside of each of the plurality of fluid flow-passages can be easily cleaned. In the fluid flow-passage device, a plurality of fluid flow-passages which extend in parallel to each other and through which a fluid is made to flow are disposed. The fluid flow-passage device comprises: a body having a plurality of substrates that are laminated in a prescribed lamination direction; and a plurality of lids, each of which can be attached to and detached from the body. Each of the plurality of fluid flow-passages includes: a first fluid flow-passage that is disposed between two substrates among the plurality of substrates, the two substrates being in contact with each other in the lamination direction; and a second fluid flow-passage that is disposed between two substrates among the plurality of substrates, the two substrates being in contact with each other in the lamination direction and being disposed at a different position in the lamination direction from the first fluid flow-passage, and that is positioned more toward the downstream side than the first fluid flow-passage in the direction in which the fluid flows.

## Description

### TECHNICAL FIELD

The present invention relates to a fluid flow-passage device in which a fluid flow-passage through which a fluid is made to flow is formed, and more particularly to a fluid flow-passage device in which a plurality of fluid flow-passages are formed so as to extend in parallel to each other.

### BACKGROUND ART

A fluid flow-passage device is known as means for mixing a plurality of fluids. The fluid flow-passage device is used for, for example, a reaction device. The reaction device is, for example, a device that mixes a plurality of fluids with one another so as to cause the fluids to chemically react with one another, thereby obtaining a target reaction product. Such a reaction device is disclosed in, for example, Patent Document 1.

The reaction device described in Patent Document 1 causes a first reactant and a second reactant to react each other while they are made to flow. The reaction device includes a flow-passage structure. The flow-passage structure includes a first introduction passage, a second introduction passage, a confluence passage, and a reaction passage.

The first introduction passage introduces the first reactant. The second introduction passage introduces the second reactant. The confluence passage connects a downstream end of the first introduction passage and a downstream end of the second introduction passage with each other. The confluence passage joins the first reactant flowing through the first introduction passage and the second reactant flowing through the second introduction passage with each other. The reaction passage is connected to a downstream end of the confluence passage. The reaction passage causes the first reactant and the second reactant, which have been joined in the confluence passage, to react each other while they are made to flow.

The flow-passage structure includes a substrate, a first sealing member, and a second sealing member. The first sealing member is bonded to one surface of the substrate so as to cover the one surface. The second sealing member is bonded to the other surface of the substrate so as to cover the other surface.

A first introduction groove and a second introduction groove are formed on the one surface of the substrate. The first introduction groove constructs the first introduction passage. The second introduction groove constructs the second introduction passage.

A reaction groove is formed on the other surface of the substrate. The reaction groove constructs the reaction passage. The reaction groove extends while meandering on the other surface of the substrate. That is, the reaction passage extends while meandering on a certain plane. In other words, the reaction passage has such a shape that a portion extending toward one side and a portion extending toward the other side on a downstream side of the portion extending toward the one side are alternately connected with each other. Therefore, a flow passage length of the reaction passage (a length in a direction of the extension of the reaction passage) is increased. As a result, an accumulation time of the first reactant and the second reactant which are joined in the confluence passage can be increased, thereby promoting the reaction between the first reactant and the second reactant.

However, the reaction passage is formed so as to meander on the certain plane in Patent Document 1, and when the reaction passage is clogged by a deposit or a foreign substance, it is difficult to remove the deposit or the foreign substance.

In order to address such a problem, a flow-passage structure described in Patent Document 2 is proposed. The flow-passage structure described in Patent Document 2 includes a body portion, a first lid portion, and a second lid portion. A second turn part connecting a portion extending toward one side and a portion disposed on a downstream side thereof, and extending toward the other side out of a confluence fluid flow-passage with each other opens on a first end surface of the body portion. A second turn part connecting a portion extending toward the other side and a portion disposed on a downstream side thereof, and extending toward the one side out of the confluence flow-passage with each other opens on a second end surface of the body portion. The first lid portion is detachably coupled to the body portion in a state in which the first lid portion is in contact with the first end surface so as to seal the opening of the first turn part. The second lid portion is detachably coupled to the body portion in a state in which the second lid portion is in contact with the second end surface so as to seal the opening of the second turn part.

A deposit or a foreign substance can be removed by detaching the first lid portion and the second lid portion from the body portion, thereby inserting a cleaning device from the first end surface side or the second end surface side of the body portion into the flow-passage in the flow-passage structure described in Patent Document 2.

### CITATION LIST

### PATENT DOCUMENT

Patent Document 1: JP2010-162428A
Patent Document 2: JP2013-56315A

### SUMMARY OF THE INVENTION

The reaction device described in Patent Document 1 and the flow-passage structure described in Patent Document 2 are used to cause a plurality of reactants, which have been joined, to react with one another. On this occasion, it is necessary to secure a sufficient period for causing the plurality of reactants, which have been joined, to react with one another depending on types of the reactants to be caused to react with one another. For that purpose, a flow passage length of the fluid flow-passage through which the plurality of reactants, which have been joined, needs to be increased as much as possible.

The flow passage length of the fluid flow-passage is increased by forming the fluid flow-passage through which the plurality of reactants, which have been joined, flow to meander on the certain plane in Patent Document 1 and Patent Document 2. However, the flow passage length of the fluid flow-passage cannot sufficiently be increased only by simply forming the fluid flow-passage to meander on the certain plane.

Particularly in Patent Document 1, the plurality of fluid flow-passages are formed so as to extend in parallel to each other on the certain plane in order to increase amounts of the flowing reactants. However, a space for forming the fluid flow-passages on the certain plane is limited. Therefore, if the plurality of fluid flow-passages are formed so as to extend in parallel to each other on the certain plane, it is more difficult to sufficiently secure the flow passage length of each of the plurality of fluid flow-passages.

It is an object of the present invention to provide such a fluid flow-passage device that even if a plurality of fluid flow-passages are formed so as to extend in parallel to each other, a flow passage length of each of the plurality of fluid flow-passages can be increased, and an inside of each of the plurality of fluid flow-passages can easily be cleaned.

The fluid flow-passage device according to the present invention is a fluid flow-passage device in which a plurality of fluid flow-passages which extend in parallel to each other and through each of which a fluid is made to flow are formed, including a body having a plurality of substrates that are laminated in a predetermined direction, a plurality of lids, each of which can be attached to and detached from the body, where each of the plurality of fluid flow-passages includes a first fluid flow-passage formed between two substrates in contact with each other in the lamination direction out of the plurality of substrates, a second fluid flow-passage formed between two substrates in contact with each other in the lamination direction out of the plurality of substrates, disposed at a position in the lamination direction different from that of the first fluid flow-passage, and positioned on a downstream side with respect to the first fluid flow-passage in the direction in which the fluid flows, and a third fluid flow-passage, which connects a downstream end of the first fluid flow-passage and an upstream end of the second fluid flow-passage with each other in the lamination direction, where the upstream end and the downstream end of the first fluid flow-passage open at least one of side surfaces respectively belonging to each of the two substrates forming the first fluid flow-passage out of the plurality of substrates, where the upstream end and the downstream end of the second fluid flow-passage open at least one of side surfaces respectively belonging to each of the two substrates forming the second fluid flow-passage out of the plurality of substrates, and where the plurality of lids include a first lid covering the upstream end of the first fluid flow-passage in a state in which the first lid is attached to the body, and a second lid covering the downstream end of the first fluid flow-passage and the upstream end of the second fluid flow-passage in a state in which the second lid is attached to the body.

With the fluid flow-passage device according to the present invention, the flow passage length of each of the plurality of fluid flow-passages can be increased, and the inside of each of the plurality of fluid flow-passages can easily be cleaned.

### BRIEF DESCRIPTION OF DRAWINGS

[Fig. 1] Fig. 1 is a plan view of a fluid flow-passage device according to an embodiment of the present invention.
[Fig. 2] Fig. 2 is a front view of the fluid flow-passage device according to the embodiment of the present invention.
[Fig. 3] Fig. 3 is a side view of a plurality of substrates constructing a body provided for the fluid flow-passage device shown in Fig. 1.
[Fig. 4] Fig. 4 is a plan view of a substrate at the lowermost position out of four substrates constructing a process flow-passage unit.
[Fig. 5] Fig. 5 is a side view, in an enlarged manner, of a part of the plurality of substrates constructing the body provided for the fluid flow-passages shown in Fig. 1.
[Fig. 6] Fig. 6 is a bottom view of a substrate overlapping the substrate shown in Fig. 4 out of the four substrates constructing the process flow-passage unit.
[Fig. 7] Fig. 7 is a plan view of flow-passages formed between the substrate shown in Fig. 4 and the substrate shown in Fig. 6.
[Fig. 8] Fig. 8 is a plan view of a substrate overlapping the substrate shown in Fig. 6 out of the four substrates constructing the process flow-passage unit.
[Fig. 9] Fig. 9 is a side view, in an enlarged manner, of a part (different from the part shown in Fig. 5) of the plurality of substrates constructing the body provided for the fluid flow-passages shown in Fig. 1.
[Fig. 10] Fig. 10 is a bottom view of a substrate overlapping the substrate shown in Fig. 8 out of the four substrates constructing the process flow-passage unit.
[Fig. 11] Fig. 11 is a plan view of flow-passages formed between the substrate shown in Fig. 8 and the substrate shown in Fig. 10.
[Fig. 12] Fig. 12 is a plan view of a part shown in Fig. 7 in an enlarged manner.
[Fig. 13] Fig. 13 is a plan view of a part shown in Fig. 11 in an enlarged manner.
[Fig. 14] Fig. 14 is a plan view of another part shown in Fig. 7 in an enlarged manner.
[Fig. 15] Fig. 15 is a plan view of another part shown in Fig. 11 in an enlarged manner.
[Fig. 16] Fig. 16 is a plan view of a substrate, on which a plurality of grooves are formed, out of a plurality of substrates constructing a temperature adjustment flow-passage unit.
[Fig. 17] Fig. 17 is a plan view of a substrate overlapping the substrate shown in Fig. 16 out of the plurality of substrates constructing the temperature adjustment flow-passage unit.
[Fig. 18] Fig. 18 is a plan view of flow-passages formed between the substrate shown in Fig. 16 and the substrate shown in Fig. 17.
[Fig. 19] Fig. 19 is a left side view of the fluid flow-passage device shown in Fig. 1.
[Fig. 20] Fig. 20 is a cross sectional view of an internal structure of a flange on a left side out of two flanges provided for the fluid flow-passage device shown in Fig. 1.
[Fig. 21] Fig. 21 is a right side view of the fluid flow-passage device shown in Fig. 1.
[Fig. 22] Fig. 22 is a cross sectional view of an internal structure of a flange on a right side out of the two flanges provided for the fluid flow-passage device shown in Fig. 1.
[Fig. 23] Fig. 23 is an explanatory diagram of directions in which fluids flow in each of the two fluid flow-passages provided for the fluid flow-passage device shown in Fig. 1.
[Fig. 24] Fig. 24 is an explanatory diagram of directions in which the fluid flows in temperature adjustment flow-passages provided for the fluid flow-passage device shown in Fig. 1.

### DESCRIPTION OF EMBODIMENTS

A detailed description will now be given of an embodiment of the present invention referring to accompanying drawings.

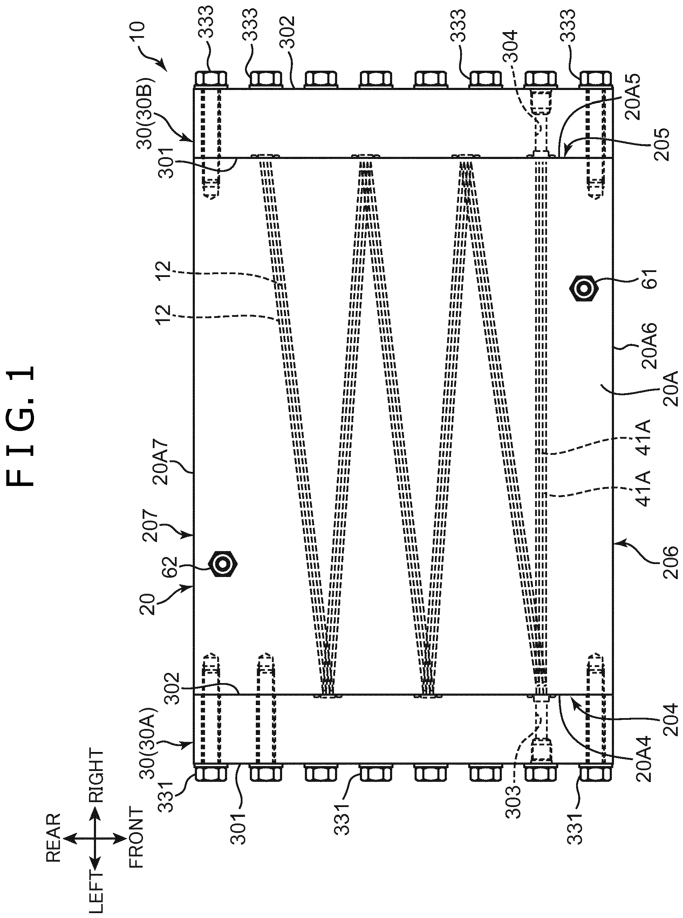

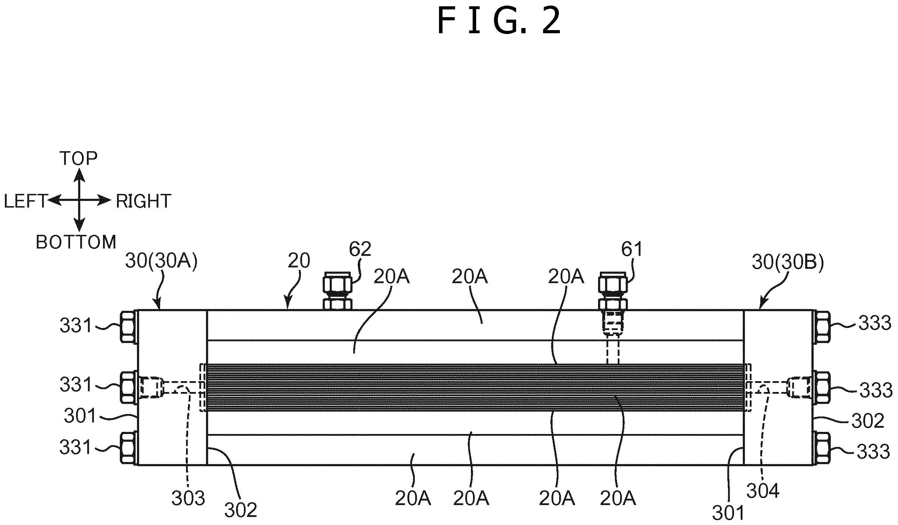

A description will now be given of a fluid flow-passage device 10 according to the embodiment of the present invention referring to Fig. 1 and Fig. 2. Fig. 1 is a plan view of the fluid flow-passage device 10. Fig. 2 is a front view of the fluid flow-passage device 10.

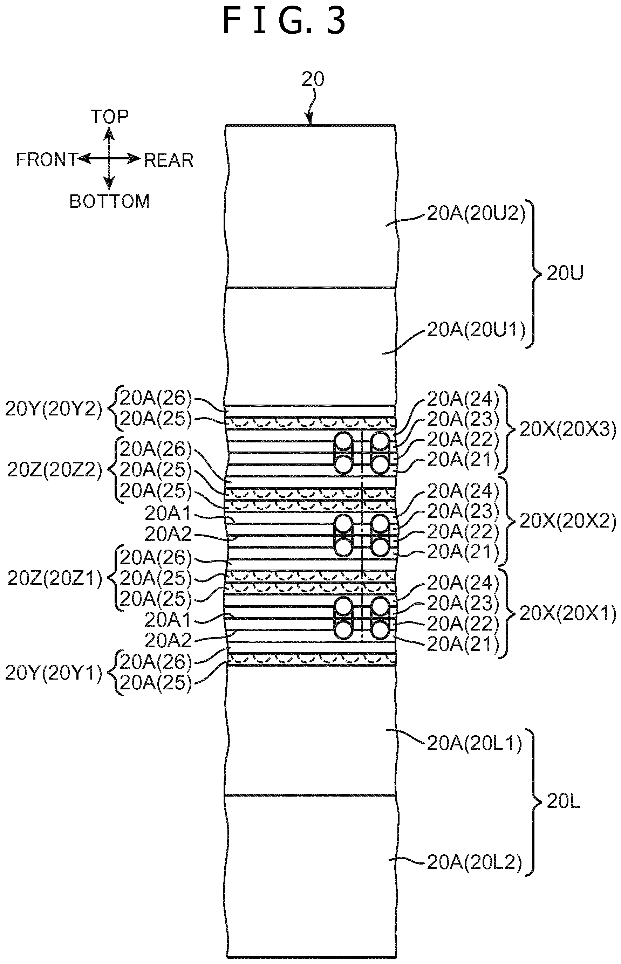

It should be noted that a top/down direction of Fig. 1 is a front/rear direction of the fluid flow-passage device 10, a left/right direction of Fig. 1 is a left/right direction of the fluid flow-passage device 10, and a direction perpendicular to the page of Fig. 1 is a top/down direction of the fluid flow-passage device 10 in the following description. The top/down direction of the fluid flow-passage device 10 is a direction in which a plurality of substrates 20A (refer to Fig. 3) described later are laminated. The direction in which the plurality of substrates 20A are laminated matches a direction of the thickness of the substrates 20A. Moreover, a cross section of a flow-passage (or a groove) is a cross section in a direction perpendicular to a direction in which the flow-passage (or the groove) extends in the following description.

The fluid flow-passage device 10 is used to join a plurality of fluids to each other, thereby generating a mutual reaction. The fluid flow-passage device 10 is used for, for example, a microchannel reactor, a heat exchanger, a reaction device for extraction reaction, a mixing device for emulsification, and the like.

As shown in Fig. 1 and Fig. 2, the fluid flow-passage device 10 includes a body 20 serving as a body, and two flanges 30 serving as a plurality of lids. A description is given thereof.

### [Body]

The body 20 has a rectangular block shape (such as a rectangular parallelepiped shape) as a whole as shown in Fig. 1. The body 20 includes a left end surface 204, a right end surface 205, a front end surface 206, and a rear end surface 207.

The body 20 includes a plurality of substrates 20A as shown in Fig. 2. The plurality of substrates 20A are laminated in the top/down direction.

Each of the plurality of substrates 20A has a rectangular plate shape as a whole as shown in Fig. 1 and Fig. 2. The plurality of substrates 20A have external shapes the same as one another as viewed in the top/down direction. Each of the plurality of substrates 20A has a left end surface 20A4, a right end surface 20A5, a front end surface 20A6, and a rear end surface 20A7.

A description will now be given of the plurality of substrates 20A referring to Fig. 3. Fig. 3 is a side view of the plurality of substrates 20A constructing the body 20.

Each of the plurality of substrates 20A includes a top surface 20A1 and a bottom surface 20A2. Each of the top surface 20A1 and the bottom surface 20A2 extend in a direction perpendicular to the lamination direction of the plurality of substrates 20A.

The plurality of substrates 20A are fixed to one another in the laminated state. Specifically, out of two substrates 20A adjacent to each other in the lamination direction (two substrates 20A overlapping in the top/down direction), a top surface 20A1 belonging to one substrate 20A (the substrate 20A on a bottom side) and a bottom surface 20A2 belonging to the other substrate 20A (the substrate 20A on a top side) are diffusion-bonded. With this configuration, a fluid is prevented from leaking from various flow-passages described later.

The left end surface 204 of the body 20 is realized by the left end surfaces 20A4 respectively belonging to the plurality of substrates 20A in the example shown in Fig. 1 and Fig. 2. The right end surface 205 of the body 20 is realized by the right end surfaces 20A5 respectively belonging to the plurality of substrates 20A. The front end surface 206 of the body 20 is realized by the front end surfaces 20A6 respectively belonging to the plurality of substrates 20A. The rear end surface 207 of the body 20 is realized by the rear end surfaces 20A7 respectively belonging to the plurality of substrates 20A.

The body 20 includes three process flow-passage units 20X, two temperature adjustment flow-passage units 20Y, and two temperature adjustment flow-passage units 20Z as shown in Fig. 3. A description will now be given thereof.

### [Process Flow-Passage Unit 20X]

Each of the three process flow-passage units 20X includes four substrates 20A. The four substrates 20A are fixed in a state in which the four substrates 20A are laminated in the top/down direction.

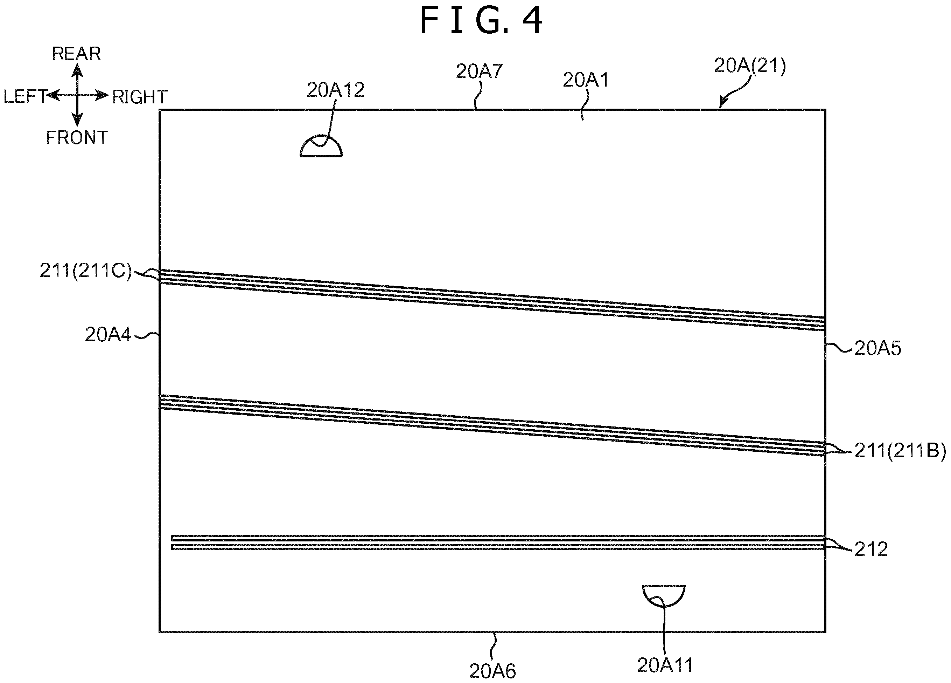

A description will now be given of the substrate 20A (hereinafter referred to as substrate 21) at the lowermost position out of the four substrates 20A constructing the process flow-passage unit 20X referring to Fig. 4. Fig. 4 is a plan view of the substrate 21.

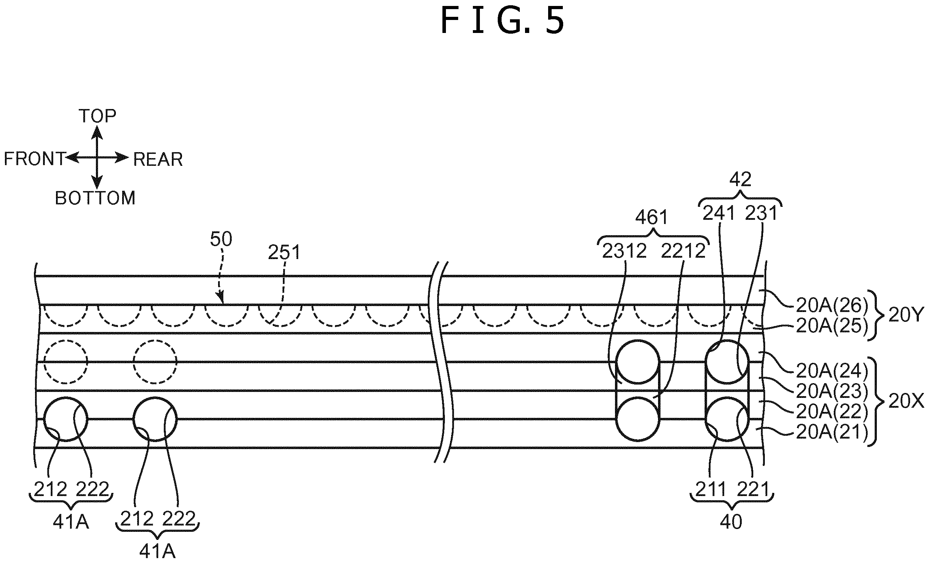

A plurality of grooves 211 are formed on the top surface 20A1 of the substrate 21. Each of the plurality of grooves 211 has an approximately constant semicircular cross section (refer to Fig. 5), and linearly extends in the left/right direction as a whole.

A left end of each of the plurality of grooves 211 opens on the left end surface 20A4 of the substrate 21. A right end of each of the plurality of grooves 211 opens on the right end surface 20A5 of the substrate 21.

The plurality of grooves 211 includes each two grooves 211B and 211C. They are formed so that each two grooves 211 forming the pair extend in parallel to each other.

Two grooves 212 are formed on a front side with respect to the plurality of grooves 211 on the top surface 20A1 of the substrate 21. The two grooves 212 are formed so as to extend in parallel to each other. Each of the two grooves 212 has an approximately constant semicircular cross section (refer to Fig. 5), and is formed so as to extend in the left/right direction.

A left end of each of the two grooves 212 is positioned close to the left end surface 20A4 of the substrate 21, but does not open on the left end surface 20A4 of the substrate 21. A right end of each of the two grooves 212 opens on the right end surface 20A5 of the substrate 21.

It should be noted that the plurality of grooves 211 and the two grooves 212 are formed, for example, by etching.

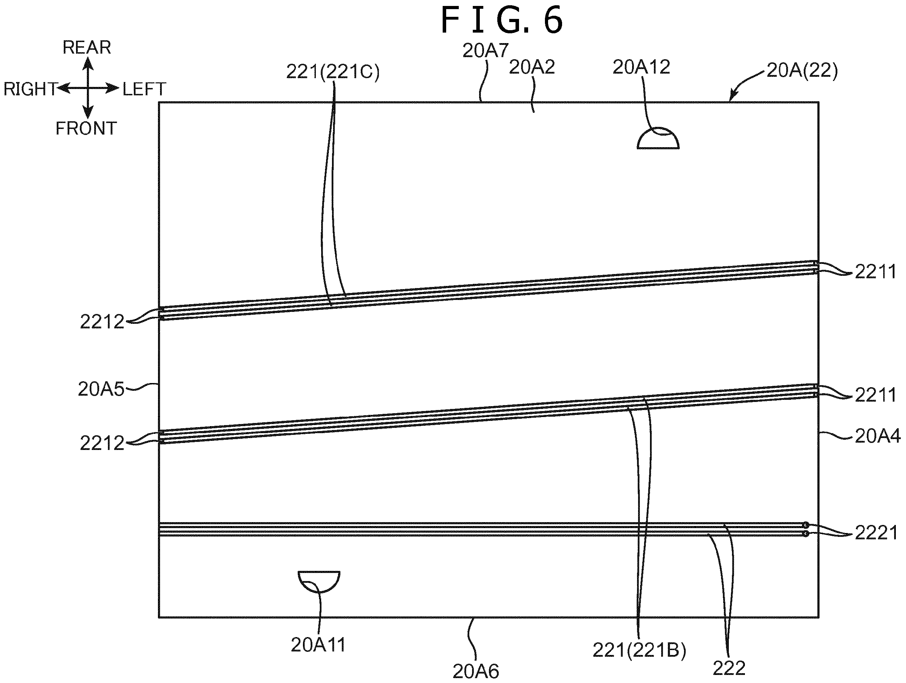

A description will now be given of the substrate 20A (hereinafter referred to as substrate 22) overlapping the substrate 21 out of the four substrates 20A constructing the process flow-passage unit 20X referring to Fig. 6. Fig. 6 is a bottom view of the substrate 22.

A plurality of grooves 221 are formed on the bottom surface 20A2 of the substrate 22. Each of the plurality of grooves 221 has an approximately constant semicircular cross section (refer to Fig. 5), and linearly extends in the left/right direction as a whole.

A left end of each of the plurality of grooves 221 opens on the left end surface 20A4 of the substrate 22. A right end of each of the plurality of grooves 221 opens on the right end surface 20A5 of the substrate 22.

A groove 2211 having an approximately constant rectangular cross section, and linearly extending in the thickness direction of the substrate 22 (the top/down direction of the substrate 22, that is, the direction perpendicular to the page in Fig. 6) is formed at the left end of each of the plurality of grooves 221.

A groove 2212 having an approximately constant rectangular cross section, and linearly extending in the thickness direction of the substrate 22 (the top/down direction of the substrate 22, that is, the direction perpendicular to the page in Fig. 6) is formed at the right end of each of the plurality of grooves 221.

The plurality of grooves 221 include each two grooves 221B and 221C. They are formed so that each two grooves 221 forming the pair extend in parallel to each other.

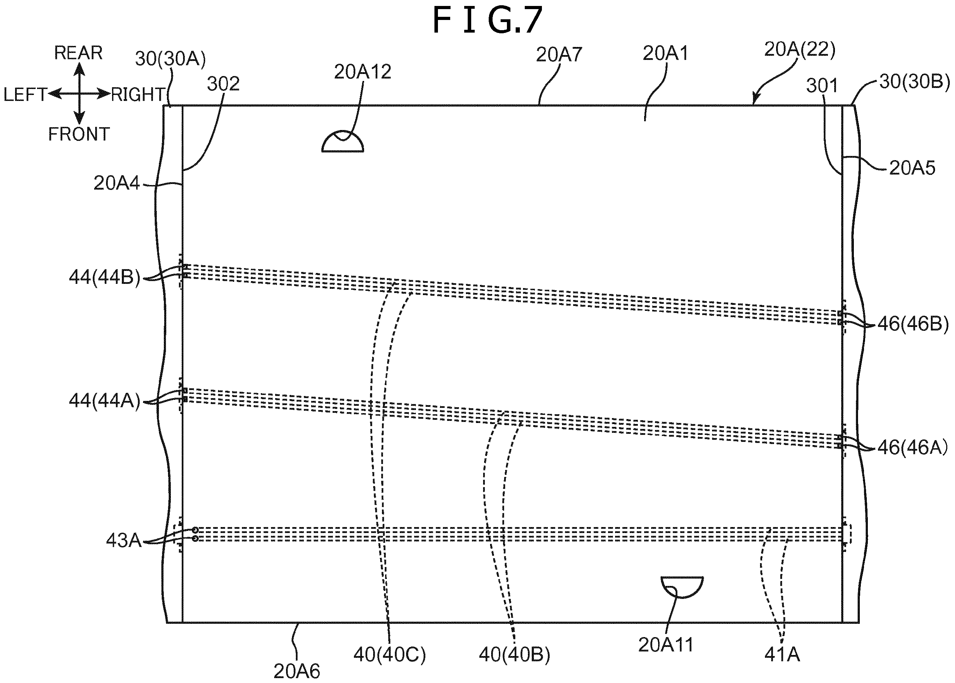

The plurality of grooves 221 are formed at positions corresponding to the plurality of grooves 211. Therefore, a plurality of flow-passages 40 are formed in the state in which the substrate 22 is laminated on the substrate 21 as shown in Fig. 7. That is, the plurality of flow-passages 40 are formed between the substrate 22 and the substrate 21.

A description will now be given of the plurality of flow-passages 40 referring to Fig. 7. Any one of the plurality of flow-passages 40 has a tunnel shape. Any one of the plurality of flow-passages 40 is formed of the one groove 211 and the one groove 221 (refer to Fig. 5). Each of the plurality of flow-passages 40 has an approximately constant circular cross section, and linearly extends in the left/right direction. A left end of each of the plurality of flow-passages 40 opens on the left end surface 20A4 of the substrate 21 and the left end surface 20A4 of the substrate 22. A right end of each of the plurality of flow-passages 40 opens on the right end surface 20A5 of the substrate 21 and the right end surface 20A5 of the substrate 22.

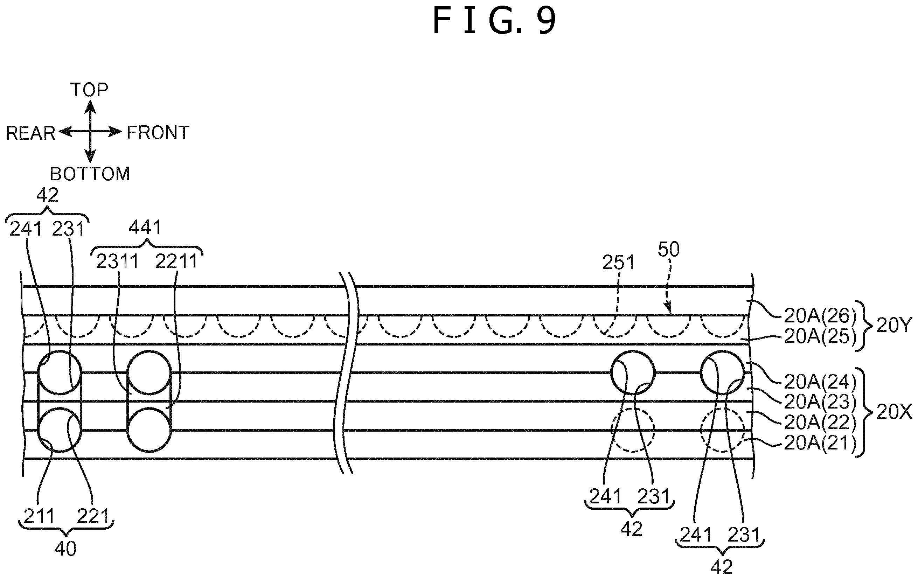

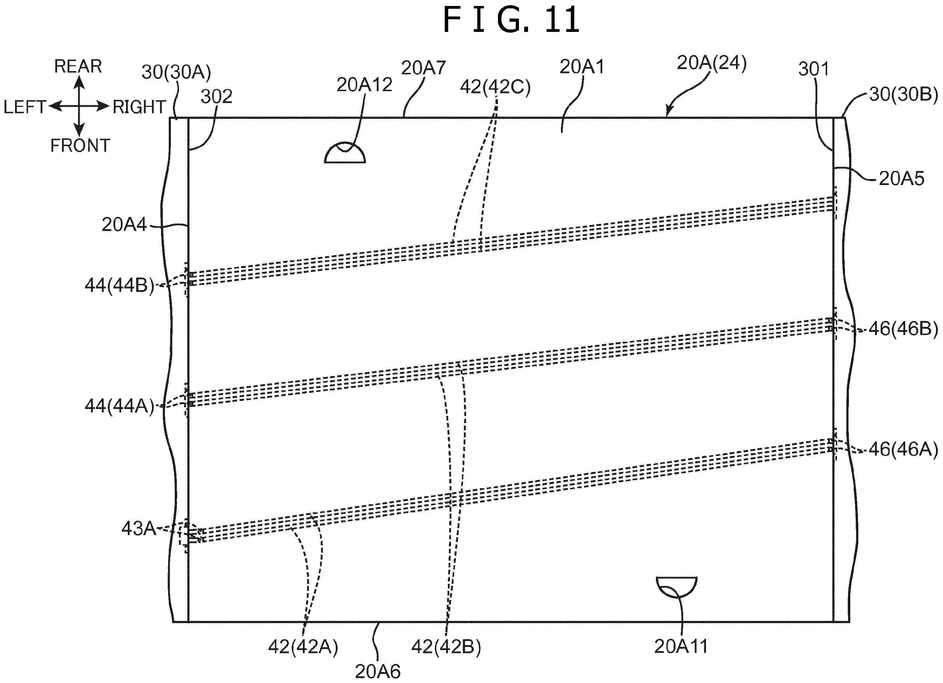

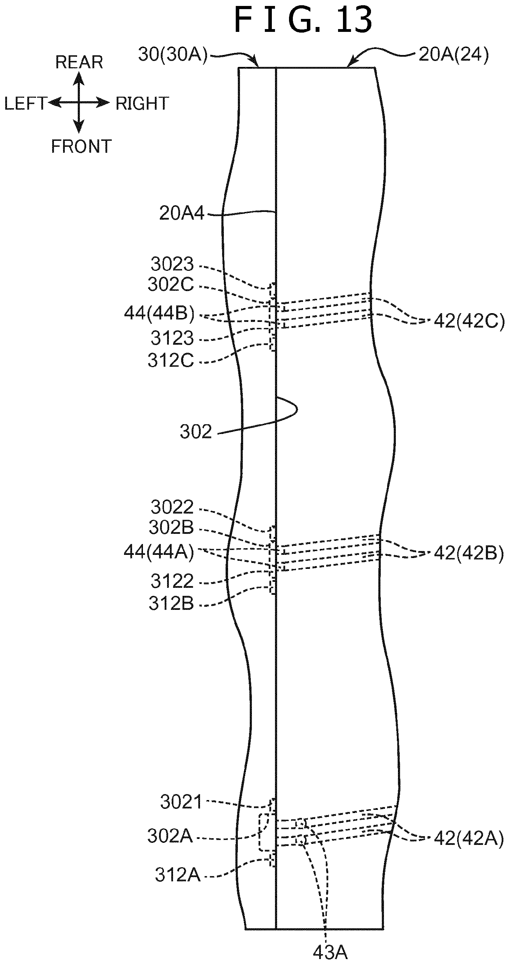

The right end of each of the plurality of flow-passages 40 is at a position different from a right end of a flow-passage 42 (refer to Fig. 11) connected via a flow-passage 44 (refer to Fig. 9, Fig. 12, and Fig. 13) provided at the left end of the same flow-passage 40 as viewed in the lamination direction of the plurality of substrates 20A.

The plurality of flow-passages 40 include each two flow-passages 40B and 40C. They are formed so that each two flow-passages 40 forming the pair extend in parallel to each other.

A description is given referring again to Fig. 6. Two grooves 222 are formed on the bottom surface 20A2 of the substrate 22. The two grooves 222 are formed so as to extend in parallel to each other. Each of the two grooves 222 has an approximately constant semicircular cross section (refer to Fig. 5), and linearly extend in the left/right direction.

A left end of each of the two grooves 222 is positioned close to the left end surface 20A4 of the substrate 22, but does not open on the left end surface 20A4 of the substrate 22. A right end of each of the two grooves 222 opens on the right end surface 20A5 of the substrate 22.

A hole 2221 is formed at the left end of each of the two grooves 222. The hole 2221 has an approximately constant circular cross section and linearly extends in the thickness direction (the top/down direction of the substrate 22, that is, the direction perpendicular to the page of Fig. 6) of the substrate 22. The hole 2221 passes through the substrate 22.

The two grooves 222 are formed at positions corresponding to the two grooves 212 on the substrate 21. Therefore, two flow-passages 41A are formed in the state in which the substrate 22 is laminated on the substrate 21 as shown in Fig. 7. That is, the two flow-passages 41A are formed between the substrate 22 and the substrate 21.

A description will now be given of the two flow-passages 41A referring to Fig. 7. Any one of the two flow-passages 41A has a tunnel shape. Any one of the two flow-passages 41A is formed of the one groove 212 and the one groove 222. Each of the two flow-passages 41A has an approximately constant circular cross section, and linearly extends in the left/right direction. A left end of each of the two flow-passages 41A is positioned close to the left end surface 20A4 of the substrate 21 and the left end surface 20A4 of the substrate 22, but does not open on the left end surface 20A4 of the substrate 21 and the left end surface 20A4 of the substrate 22. A right end of each of the two flow-passages 41A opens on the right end surface 20A5 of the substrate 21 and the right end surface 20A5 of the substrate 22.

It should be noted that the plurality of grooves 221 and the two grooves 222 are formed, for example, by etching. The hole 2221 provided for each of the two grooves 222 is formed by, for example, cutting or the like. The groove 2211 positioned at the left end of each of the plurality of grooves 221 is formed by, for example, forming a hole opening on a bottom surface of each of the plurality of grooves 221 by cutting or the like, and, then, cutting the left end surface of the substrate 21. The groove 2212 positioned at the right end of each of the plurality of grooves 221 is formed by, for example, forming a hole opening on the bottom surface of each of the plurality of grooves 221 by cutting or the like, and, then, cutting the right end surface of the substrate 21.

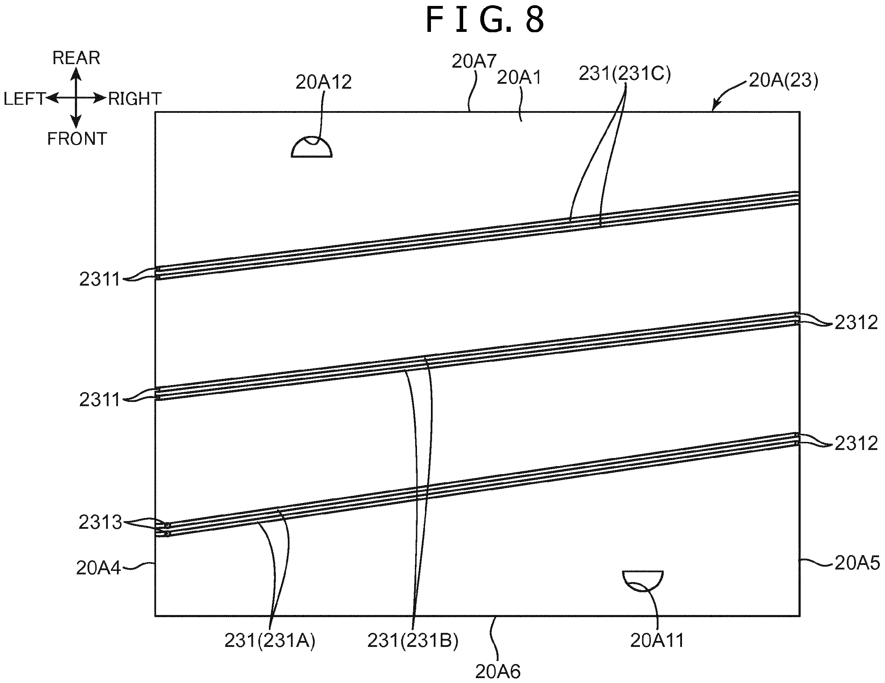

A description will now be given of the substrate 20A (hereinafter referred to as substrate 23) overlapping the substrate 22 out of the four substrates 20A constructing the process flow-passage unit 20X referring to Fig. 8. Fig. 8 is a plan view of the substrate 23.

A plurality of grooves 231 are formed on the top surface 20A1 of the substrate 23. Each of the plurality of grooves 231 has an approximately constant semicircular cross section (refer to Fig. 9), and linearly extends in the left/right direction as a whole.

A left end of each of the plurality of grooves 231 opens on the left end surface 20A4 of the substrate 23. A right end of each of the plurality of grooves 231 opens on the right end surface 20A5 of the substrate 23.

A groove 2311 having an approximately constant rectangular cross section, and linearly extending in the thickness direction of the substrate 23 (the top/down direction of the substrate 23, that is, the direction perpendicular to the page in Fig. 8) is formed at the left end of each of the plurality of grooves 231 (it should be noted that the left end of each of the two grooves 231A is excluded).

A groove 2312 having an approximately constant rectangular cross section, and linearly extending in the thickness direction of the substrate 23 (the top/down direction of the substrate 23, that is, the direction perpendicular to the page in Fig. 8) is formed at the right end of each of the plurality of grooves 231 (it should be noted that the right end of each of the two grooves 231C is excluded).

The plurality of grooves 231 include each two grooves 231A to 231C. They are formed so that each two grooves 231 forming the pair extend in parallel to each other.

A hole 2313 is formed in a vicinity of the left end of each of the two grooves 231A. The hole 2313 has an approximately constant circular cross section and linearly extends in the thickness direction (the top/down direction of the substrate 23, that is, the direction perpendicular to the page of Fig. 8) of the substrate 23. The hole 2313 passes through the substrate 23.

It should be noted that the plurality of grooves 231 are formed, for example, by etching. The hole 2313 provided for each of the two grooves 231A is formed by, for example, cutting or the like. The groove 2311 positioned at the left end of each of the plurality of grooves 231 is formed by, for example, forming a hole opening on a bottom surface of each of the plurality of grooves 231 by cutting or the like, and, then, cutting a left end surface of the substrate 23. The groove 2312 positioned at the right end of each of the plurality of grooves 231 is formed by, for example, forming a hole opening on the bottom surface of each of the plurality of grooves 231 by cutting or the like, and, then, cutting a right end surface of the substrate 23.

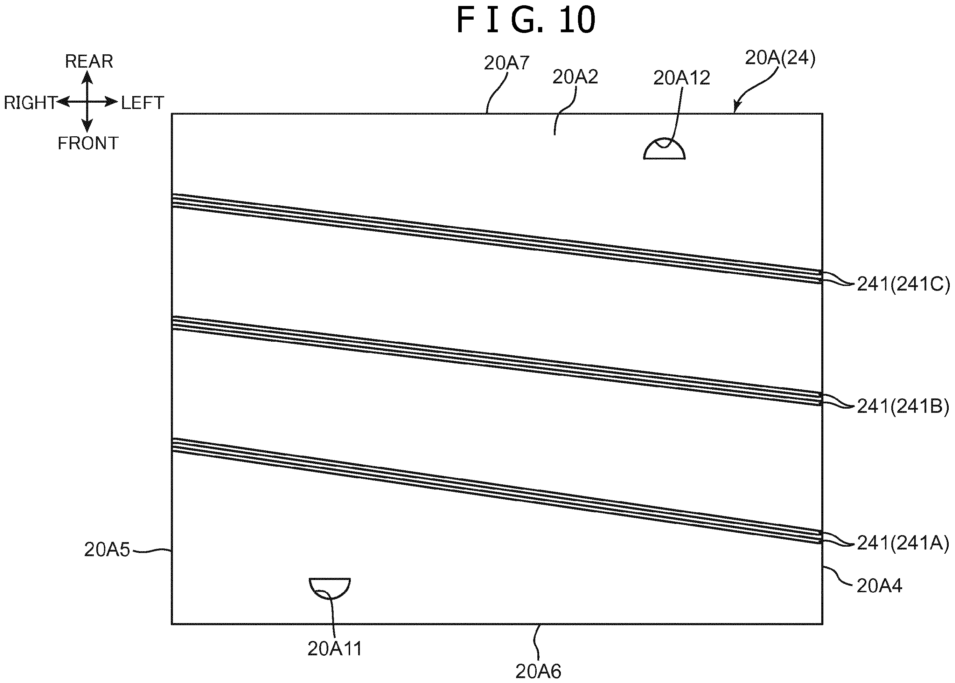

A description will now be given of the substrate 20A (hereinafter, referred to as substrate 24) overlapping the substrate 23 out of the four substrates 20A referring to Fig. 10. Fig. 10 is a bottom view of the substrate 24.

A plurality of grooves 241 are formed on the bottom surface 20A2 of the substrate 24. Each of the plurality of grooves 241 has an approximately constant semicircular cross section (refer to Fig. 9), and linearly extends in the left/right direction.

A left end of each of the plurality of grooves 241 opens on the left end surface 20A4 of the substrate 24. A right end of each of the plurality of grooves 241 opens on the right end surface 20A5 of the substrate 24.

The plurality of grooves 241 include each two grooves 241A to 241C. They are formed so that each two grooves 241 forming the pair extend in parallel to each other.

The plurality of grooves 241 are formed at positions corresponding to the plurality of grooves 231. Therefore, a plurality of flow-passages 42 are formed in the state in which the substrate 24 is laminated on the substrate 23 as shown in Fig. 11. That is, the plurality of flow-passages 42 are formed between the substrate 24 and the substrate 23.

A description will now be given of the plurality of flow-passages 42 referring to Fig. 11. Any one of the plurality of flow-passages 42 has a tunnel shape. Any one of the plurality of flow-passages 42 is formed of the one groove 231 and the one groove 241 (refer to Fig. 9). Each of the plurality of the flow-passages 42 has an approximately constant circular cross section, and linearly extends in the left/right direction. A left end of each of the plurality of flow-passages 42 opens on the left end surface 20A4 of the substrate 23 and the left end surface 20A4 of the substrate 24. A right end of each of the plurality of flow-passages 42 opens on the right end surface 20A5 of the substrate 23 and the right end surface 20A5 of the substrate 24.

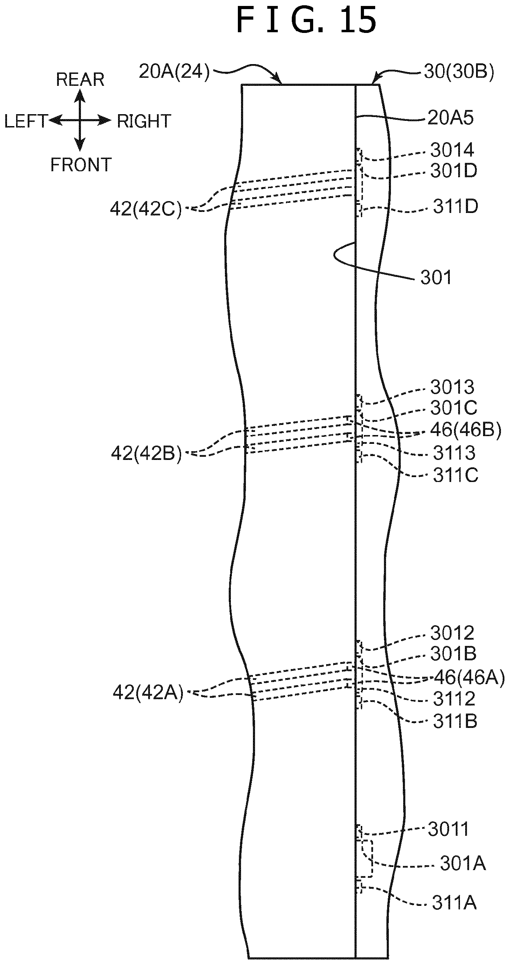

The left end of each of the plurality of flow-passages 42 is at a position different from the left end of the flow-passage 40 (refer to Fig. 7) connected via a flow-passage 46 (refer to Fig. 5, Fig. 14, and Fig. 15) provided at the right end of the same flow-passage 42 as viewed in the lamination direction of the plurality of substrates 20A.

The plurality of flow-passages 42 include each two flow-passages 42A to 42C. They are formed so that each two flow-passages 42 forming the pair extend in parallel to each other.

It should be noted that the plurality of grooves 241 are formed, for example, by etching.

The two holes 2221 formed in the substrate 22 are at positions corresponding to the two holes 2321 formed in the substrate 23 in the state in which the substrate 23 is laminated on the substrate 22. Flow-passages 43A each having an approximately constant circular cross section, and linearly extending in the top/down direction are formed of the holes 2221 and the holes 2321 (refer to Fig. 7 and Fig. 11). That is, the two flow-passages 43A are formed in the process flow-passage unit 20X.

A top end of the flow-passage 43A is connected to the flow-passage 42A. A bottom end of the flow-passage 43A is connected to the flow-passage 41A.

The plurality of grooves 2311 are at positions corresponding to the plurality of grooves 2211 in the state in which the substrate 23 is laminated on the substrate 22 as shown in Fig. 9, Fig. 12, and Fig. 13. The groove 441 is formed of the groove 2311 and the groove 2211. That is, the plurality of grooves 441 are formed in the process flow-passage unit 20X.

A description will now be given of the plurality of grooves 441 referring to Fig. 9, Fig. 12, and Fig. 13. Each of the plurality of grooves 441 is covered by a flange 30A described later. As a result, the plurality of flow-passages 44 are formed. Each of the plurality of the flow-passages 44 has an approximately constant cross section, and linearly extends in the top/down direction.

A top end of each of the plurality of flow-passages 44 is connected to the left end of the flow-passage 42. A bottom end of each of the plurality of flow-passages 44 is connected to the left end of the flow-passage 40.

The plurality of flow-passages 44 include each two flow-passages 44A and 44B. They are formed so that each two flow-passages 44 forming the pair extend in parallel to each other.

The plurality of grooves 2312 are at positions corresponding to the plurality of grooves 2212 in the state in which the substrate 23 is laminated on the substrate 22 as shown in Fig. 5, Fig. 14, and Fig. 15. The groove 461 is formed of the groove 2312 and the groove 2212. That is, the plurality of grooves 461 are formed in the process flow-passage unit 20X.

A description will now be given of the plurality of grooves 461 referring to Fig. 5, Fig. 14, and Fig. 15. Each of the plurality of grooves 461 is covered by a flange 30B described later. As a result, the plurality of flow-passages 46 are formed. Each of the plurality of the flow-passages 46 has an approximately constant cross section, and linearly extends in the top/down direction.

A top end of each of the plurality of flow-passages 46 is connected to the right end of the flow-passage 42. A bottom end of each of the plurality of flow-passages 46 is connected to the right end of the flow-passage 40.

The plurality of flow-passages 46 include each two flow-passages 46A and 46B. They are formed so that each two flow-passages 46 forming the pair extend in parallel to each other.

### [Temperature Adjustment Flow-Passage Unit 20Y]

A description will now be given of the two temperature adjustment flow-passage units 20Y provided for the body 20 referring to Fig. 3. Each of the two temperature adjustment flow-passage units 20Y includes two substrates 20A. The two substrates 20A are fixed in a state in which the two substrates 20A are laminated in the top/down direction.

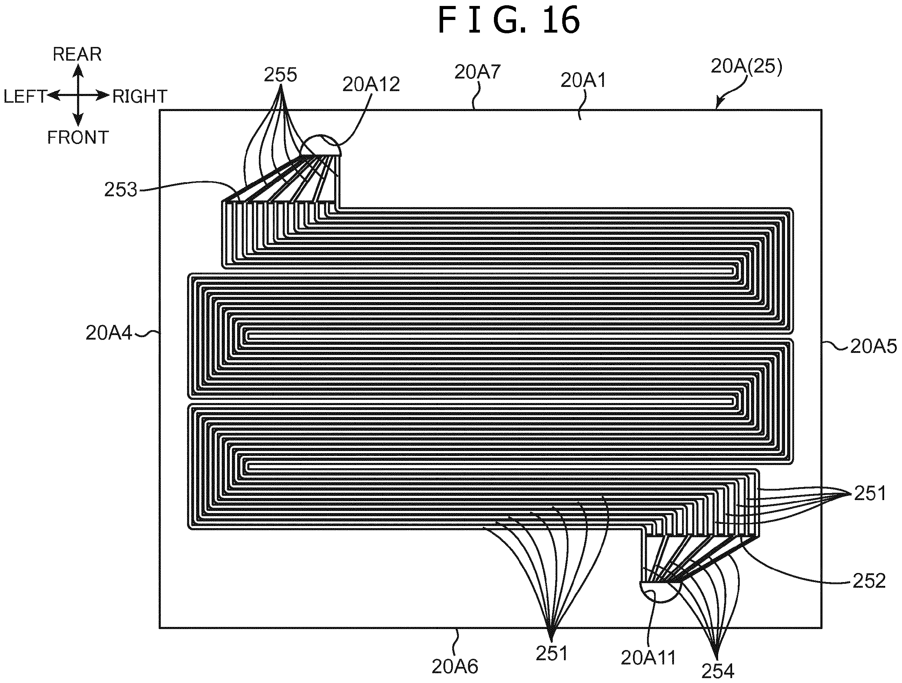

A description will now be given of the substrate 20A (hereinafter referred to as substrate 25) at a lower position out of the two substrates 20A constructing the temperature adjustment flow-passage unit 20Y referring to Fig. 16. Fig. 16 is a plan view of the substrate 25.

A plurality of grooves 251 are formed on the top surface 20A1 of the substrate 25. The plurality of grooves 251 extend in parallel to one another while meandering.

A groove 252 extending in the left/right direction is formed on the top surface 20A1 of the substrate 25. A front end of each of the plurality of grooves 251 is connected to the groove 252.

A groove 253 extending in the left/right direction is formed on the top surface 20A1 of the substrate 25. A rear end of each of the plurality of grooves 251 is connected to the groove 253.

A hole 20A11 is formed in the substrate 25. The hole 20A11 is positioned forward of the groove 252 in the front/rear direction of the substrate 25. The hole 20A11 has an approximately constant semicircular cross section, and extends in a thickness direction of the substrate 25. It should be noted that the hole 20A11 is also formed in each of the four substrates 21 to 24 constructing the process flow-passage unit 20X.

A hole 20A512 is formed in the substrate 25. The hole 20A12 is positioned backward of the groove 253 in the front/rear direction of the substrate 25. The hole 20A12 has an approximately constant semicircular cross section, and extends in the thickness direction of the substrate 25. It should be noted that the hole 20A12 is also formed in each of the four substrates 21 to 24 constructing the process flow-passage unit 20X.

A plurality of grooves 254 are formed on the top surface 20A1 of the substrate 25. The plurality of grooves 254 connect the groove 252 and the hole 20A11 with each other.

A plurality of grooves 255 are formed on the top surface 20A1 of the substrate 25. The plurality of grooves 255 connect the groove 253 and the hole 20A12 with each other.

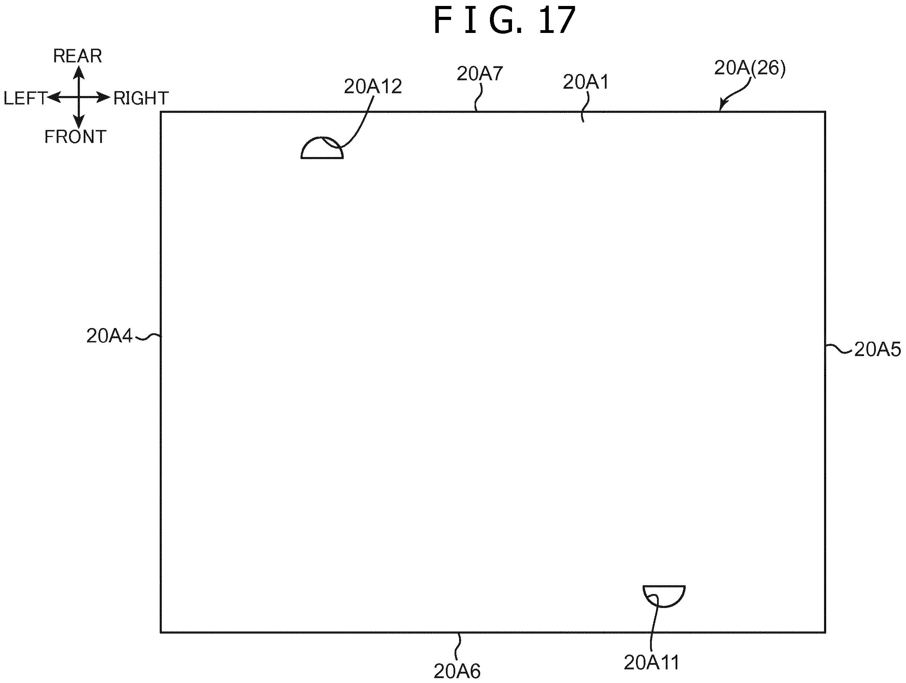

A description will now be given of the substrate 20A (hereinafter referred to as substrate 26) laminated on the substrate 25 out of the two substrates 20A constructing the temperature adjustment flow-passage unit 20Y referring to Fig. 17. Fig. 17 is a plan view of the substrate 26.

The substrate 26 is different from the substrate 25 in such a point that the plurality of grooves 251, the groove 252, the groove 253, the plurality of grooves 254, and the plurality of grooves 255 are not formed. That is, grooves are not formed on each of the top surface 20A1 and the bottom surface 20A2 of the substrate 26.

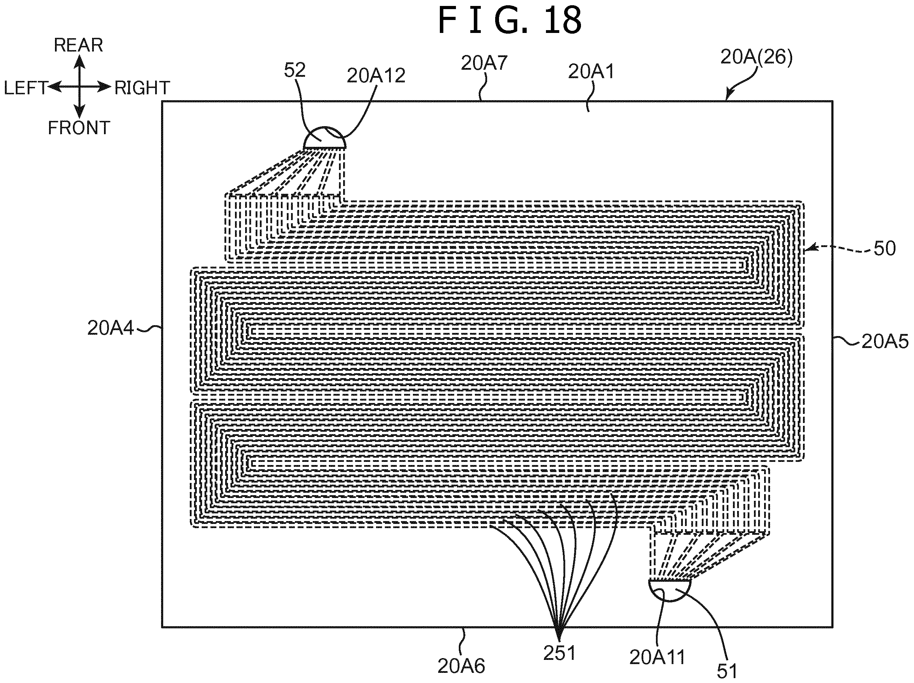

The substrate 26 is laminated on the substrate 25 in the top/down direction as shown in Fig. 3. All the grooves 251 to 255 formed on the top surface 20A1 of the substrate 25 are covered with the bottom surface 20A2 of the substrate 26 in this state. As a result, a flow-passage 50 is formed of the plurality of grooves 251, the groove 252, the groove 253, the plurality of grooves 254, and the plurality of grooves 255 as shown in Fig. 18.

### [Temperature Adjustment Flow-Passage Unit 20Z]

A description will now be given of the two temperature adjustment flow-passage units 20Z provided for the body 20 referring to Fig. 3. Each of the two temperature adjustment flow-passage units 20Z includes three substrates 20A. The three substrates 20A are fixed to one another in a state in which the three substrates 20A are laminated in the top/down direction.

The three substrates 20A are constructed by two substrates 25 and one substrate 26.

All the grooves 251 to 255 formed on the top surface 20A1 of the substrate 25 on a bottom side are covered with the bottom surface 20A2 of the substrate 25 on a top side in a state in which the two substrates 25 are laminated. The flow-passage 50 is formed of the plurality of grooves 251, the groove 252, the groove 253, the plurality of grooves 254, and the plurality of grooves 255 as in the temperature adjustment flow-passage unit 20Y.

All the grooves 251 to 255 formed on the top surface 20A1 of the substrate 25 are covered with the bottom surface 20A2 of the substrate 26 in the state in which the substrate 26 is laminated on the substrate 25. The flow-passage 50 is formed of the plurality of grooves 251, the groove 252, the groove 253, the plurality of grooves 254, and the plurality of grooves 255 as in the temperature adjustment flow-passage unit 20Y.

The three process flow-passage units 20X, the two temperature adjustment flow-passage units 20Y, and the two temperature adjustment flow-passage units 20Z are laminated in a predetermined order in the top/down direction as shown in Fig. 3. A description will now be given of the lamination of these units 20X, 20Y, and 20Z referring to Fig. 3.

It should be noted that the three process flow-passage units 20X are constructed by a process flow-passage unit 20X1, a process flow-passage unit 20X2, and a process flow-passage unit 20X3 in the following description. The two temperature adjustment flow-passage units 20Y are constructed by a temperature adjustment flow-passage unit 20Y1 and a temperature adjustment flow-passage unit 20Y2. The two temperature adjustment flow-passage units 20Z are constructed by a temperature adjustment flow-passage unit 20Z1 and a temperature adjustment flow-passage unit 20Z2.

The process flow-passage unit 20X1 is laminated on the temperature adjustment flow-passage unit 20Y1. The temperature adjustment flow-passage unit 20Z1 is laminated on the process flow-passage unit 20X1. The process flow-passage unit 20X2 is laminated on the temperature adjustment flow-passage unit 20Z1. The temperature adjustment flow-passage unit 20Z2 is laminated on the process flow-passage unit 20X2. The process flow-passage unit 20X3 is laminated on the temperature adjustment flow-passage unit 20Z2. The temperature adjustment flow-passage unit 20Y2 is laminated on the process flow-passage unit 20X3.

### [Top End Unit 20U]

The body 20 further includes a top end unit 20U as shown in Fig. 3. A description will now be given of the top end unit 20U referring to Fig. 3.

The top end unit 20U is laminated on the temperature adjustment flow-passage unit 20Y2. The top end unit 20U includes two substrates 20A. The two substrates 20A are constructed by a substrate 20U1 and a substrate 20U2.

The substrate 20U1 is different from the substrate 26 in such a point as being thicker.

The substrate 20U2 is different from the substrate 26 in such a point as being thicker. The substrate 20U2 is different from the substrate 26 in such a point that the two holes 20A11 and 20A12 are not formed. Instead, two screw holes (not shown) are formed at positions corresponding to the two holes 20A11 and 20A12 in the substrate 20U2. Each of the two screw holes passes through the substrate 20U2 in the thickness direction. A connector 61 (refer to Fig. 1 and Fig. 2) is attached to the screw hole formed at the position corresponding to the hole 20A11. A connector 62 (refer to Fig. 1 and Fig. 2) is attached to the screw hole formed at the position corresponding to the hole 20A12. The substrate 20U2 is positioned above the substrate 20U1.

### [Bottom End Unit 20L]

The body 20 further includes a bottom end unit 20L as shown in Fig. 3. A description will now be given of the bottom end unit 20L referring to Fig. 3.

The bottom end unit 20L is laminated on the temperature adjustment flow-passage unit 20Y1. The bottom end unit 20L includes two substrates 20A. The two substrates 20A are constructed by a substrate 20L1 and a substrate 20L2.

The substrate 20L1 is different from the substrate 26 in such a point as being thicker.

The substrate 20L2 is different from the substrate 26 in such a point as being thicker. The substrate 20L2 is different from the substrate 26 in such a point that the two holes 20A11 and 20A12 are not formed. The substrate 20L2 is positioned below the substrate 20L1.

Two flow-passages 51 and 52 are formed in the body 20 in a state in which the top end unit 20U is laminated on the temperature adjustment flow-passage unit 20Y2, and the bottom end unit 20L is laminated on the temperature adjustment flow-passage unit 20Y1.

The flow-passage 51 is realized by the hole 20A11 formed in each of the substrates 20A except for the substrate 20A (substrate 20U2) positioned at the top end and the substrate 20A (substrate 20L2) positioned at the bottom end out of the plurality of substrates 20A. The flow-passage 51 is connected to one end of the flow-passage 50. The flow-passage 51 is connected to the connector 61.

The flow-passage 52 is realized by the hole 20A12 formed in each of the substrates 20A except for the substrate 20A (substrate 20U2) positioned at the top end and the substrate 20A (substrate 20L2) positioned at the bottom end out of the plurality of substrates 20A. The flow-passage 52 is connected to the other end of the flow-passage 50. The flow-passage 52 is connected to the connector 62.

### [Flanges]

A description will now be given of the two flanges 30 referring to Fig. 1 and Fig. 2. Each of the two flanges 30 has a rectangular plate shape as a whole. Each of the two flanges 30 has a left surface 301 and a right surface 302.

The two flanges 30 are detachably attached to the body 20. Specifically, one flange 30 (hereinafter flange 30A) out of the two flanges 30 is detachably attached to the left end surface 204 of the body 20. The other flange 30 (hereinafter flange 30B) out of the two flanges 30 is detachably attached to the right end surface 205 of the body 20.

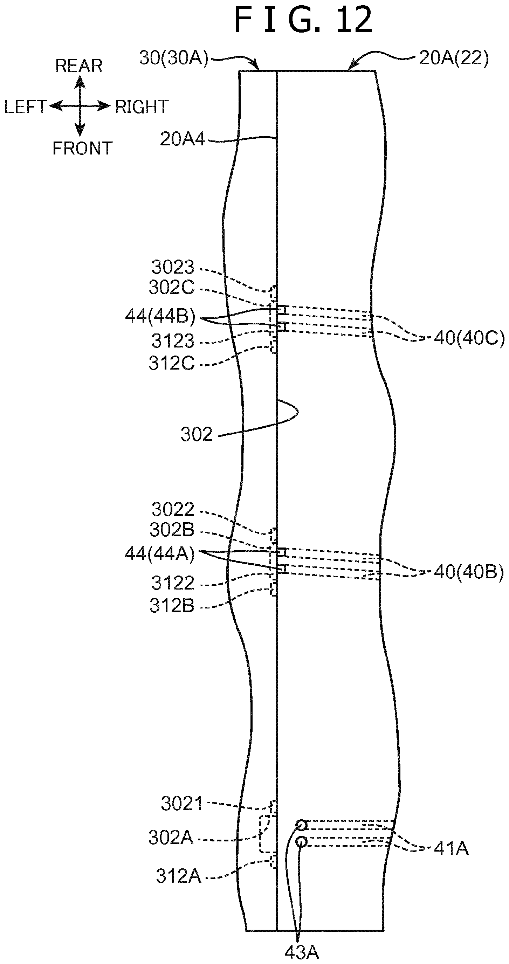

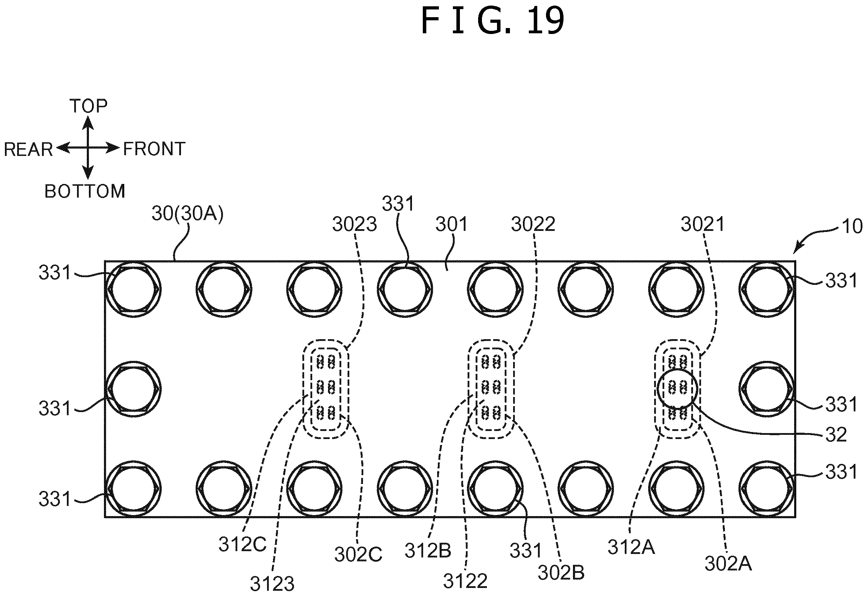

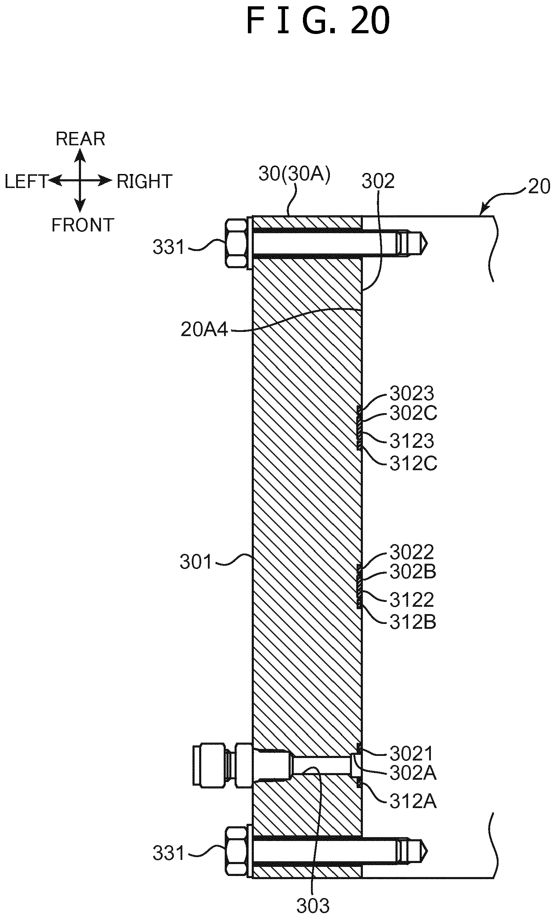

A description will now be given of the flange 30A referring to Fig. 12, Fig. 13, Fig. 19, and Fig. 20. Fig. 19 is a left side view of the fluid flow-passage device 10. Fig. 20 is a cross sectional view of the flange 30A.

A plurality of recess portions 302A to 302C and a plurality of annular grooves 3021 to 3023 are formed on the right surface 302 of the flange 30A. A description will now be given thereof.

The plurality of recess portions 302A to 302C are formed so as to respectively cover any of the openings of the plurality of the flow-passages 40 and the plurality of flow-passages 42 belonging to each of the three process flow-passage units 20X as viewed from the left side of the fluid flow-passage device 10. Each of the plurality of annular grooves 3021 to 3023 is formed so as to surround any of the plurality of recess portions 302A to 302C.

A seal member 3122 in a sheet form is accommodated in the recess portion 302B. The seal member 3122 is sandwiched between the flange 30A and the body 20 in a state in which the flange 30A is attached to the body 20. On this occasion, the seal member 3122 covers the two grooves 441 respectively belonging to each of the three process flow-passage units 20X. As a result, the two flow-passages 44A are sealed.

A seal member 3123 in a sheet form is accommodated in the recess portion 302C. The seal member 3123 is sandwiched between the flange 30A and the body 20 in the state in which the flange 30A is attached to the body 20. On this occasion, the seal member 3123 covers the two grooves 441 belonging to each of the three process flow-passage units 20X. As a result, the two flow-passages 44B are sealed.

A hole 303 is formed at a position corresponding to the recess portion 302A in the flange 30A.

A connector 32 is attached to the flange 30A. The connector 32 is attached to the flange 30A in a state in which the connector 32 is inserted into the hole 303.

The flange 30A is fixed to the left end surface 204 of the body 20 by a plurality of bolts 331. A right side surface 302 of the flange 30A is in contact with the left end surface 204 of the body 20 in the state in which the flange 30A is fixed to the body 20.

A plurality of seal members 312A to 312C each one of which is disposed in each of the plurality of the annular grooves 3021 to 3023 are respectively sandwiched between the flange 30A and the body 20 in this state. As a result, a periphery of each of the plurality of recess portions 302A to 302C is sealed.

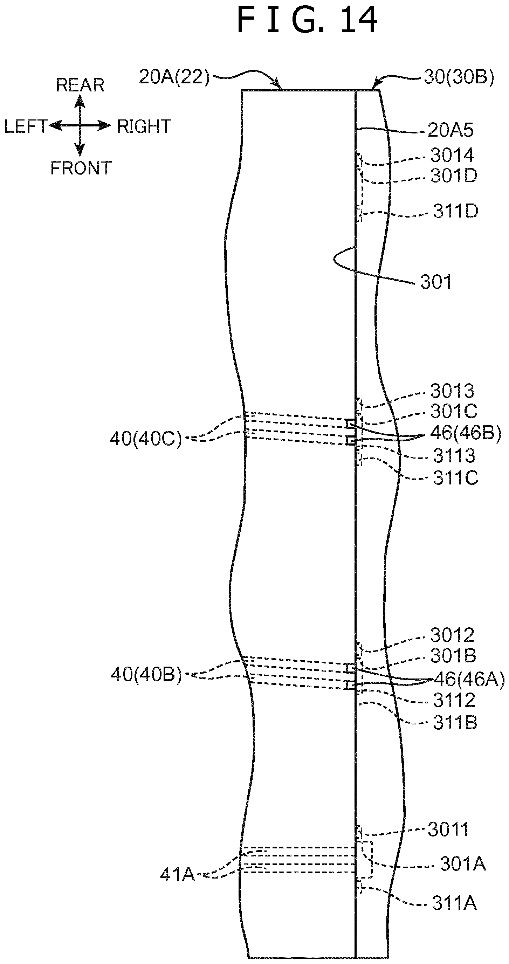

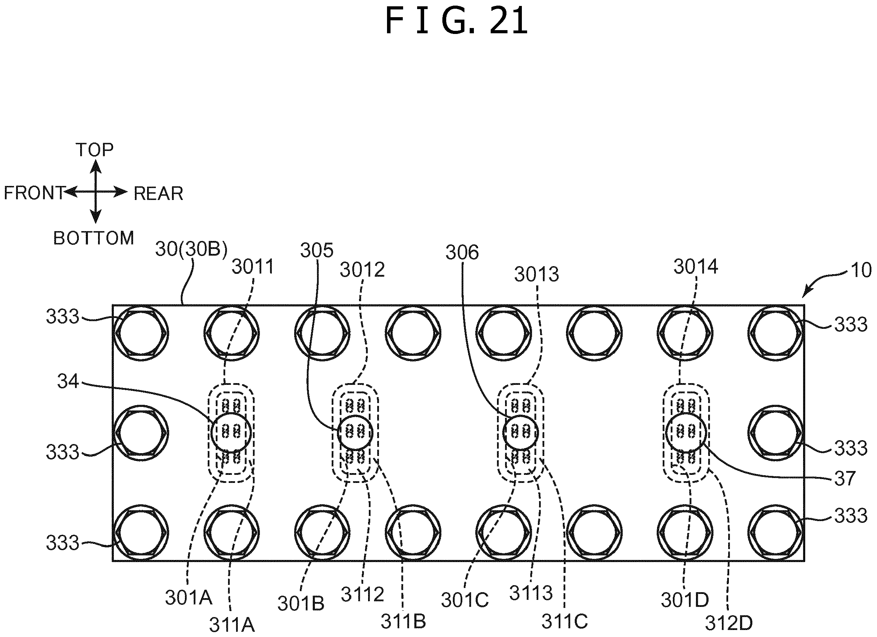

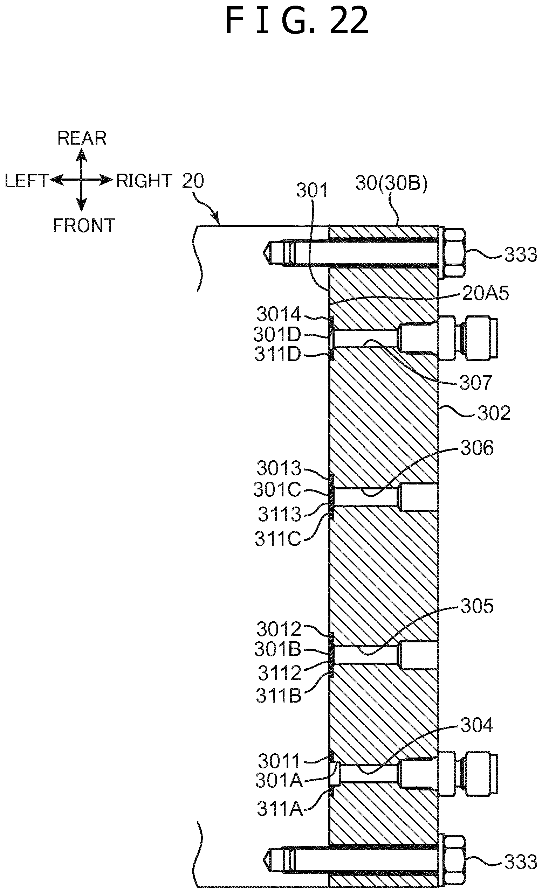

A description will now be given of the flange 30B referring to Fig. 14, Fig. 15, Fig. 21, and Fig. 22. Fig. 21 is a right side view of the fluid flow-passage device 10. Fig. 22 is a cross sectional view of the flange 30B.

A plurality of recess portions 301A to 301D and a plurality of annular grooves 3011 to 3014 are formed on the left surface 301 of the flange 30B. A description will now be given thereof.

The plurality of recess portions 301A to 301D are formed so as to respectively cover any of the openings of the plurality of the flow-passages 40 and the plurality of flow-passages 42 belonging to each of the three process flow-passage units 20X as viewed from the right side of the fluid flow-passage device 10. Each of the plurality of annular grooves 3011 to 3014 is formed so as to surround any of the plurality of recess portions 301A to 3014.

A seal member 3112 in a sheet form is accommodated in the recess portion 301B. The seal member 3112 is sandwiched between the flange 30B and the body 20 in the state in which the flange 30B is attached to the body 20. On this occasion, the seal member 3112 covers the two grooves 461 respectively belonging to each of the three process flow-passage units 20X. As a result, the two flow-passages 46A are sealed.

A seal member 3113 in a sheet form is accommodated in the recess portion 301C. The seal member 3113 is sandwiched between the flange 30B and the body 20 in the state in which the flange 30B is attached to the body 20. On this occasion, the seal member 3113 covers the two grooves 461 respectively belonging to each of the three process flow-passage units 20X. As a result, the two flow-passages 46B are sealed.

A plurality of holes 304 to 307 are formed in the flange 30B. The plurality of holes 304 to 307 are formed at positions corresponding to the plurality of recess portions 301A to 301D.

Two connectors 34 and 37 are attached to the flange 30B. The connector 34 is fixed to the flange 30B in a state in which the connector 34 is inserted into the hole 304. The connector 37 is fixed to the flange 30B in a state in which the connector 37 is inserted into the hole 307.

The flange 30B is fixed to the left end surface 204 of the body 20 by a plurality of bolts 333. A left side surface 301 of the flange 30B is in contact with the right end surface 205 of the body 20 in the state in which the flange 30B is fixed to the body 20.

A plurality of seal members 312A to 312D each one of which is disposed in each of the plurality of the annular grooves 3011 to 3014 are respectively sandwiched between the flange 30B and the body 20 in this state. As a result, a periphery of each of the plurality of recess portions 301A to 301D is sealed.

### [Flow of Fluid in Fluid Flow-Passage Device]

A description will now be given of the flows of the fluids in the fluid flow-passage device 10 referring to Fig. 1, Fig. 7, and Fig. 11.

The fluid flow-passage device 10 includes the two flow-passages 12 and the two flow-passages 41A for each one of process flow-passage units 20X as shown in Fig. 1. Each of the two flow-passages 12 includes the plurality of flow-passages 40B and 40C, the plurality of flow-passages 42A to 42C, the plurality of flow-passages 44A and 44B, and the plurality of flow-passages 46A and 46B.

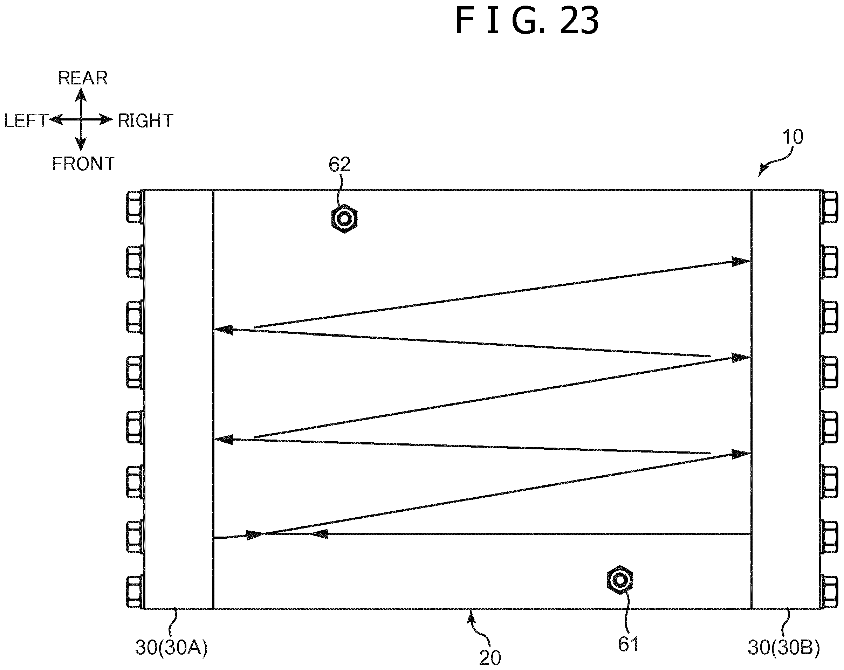

Each of the two flow-passages 12 makes the fluids to flow as shown in Fig. 23. A specific description will now be given.

A first fluid is introduced into the flow-passages 42A serving as first fluid flow-passages via the connector 32 and the hole 303. The first fluid introduced into the flow-passages 42A flows from the right side toward the left side of the fluid flow-passage device 10 through the flow-passages 42A.

A second fluid is introduced into the flow-passages 41A serving as introduction flow-passages via the connector 34 and the hole 304. The second fluid introduced into the flow-passages 41A flows from the left side toward the right side of the fluid flow-passage device 10 through the flow-passages 41A.

The second fluid flowing through the flow-passages 41A is introduced into the flow-passages 42A via the flow-passages 43A. As a result, the second fluid flows through the flow-passages 42A together with the first fluid. The fluid in the state in which the second fluid flows together with the first fluid is referred to as mixed fluid hereinafter.

The mixed fluid flowing through the flow-passages 42A is introduced into the flow-passages 40B serving the second fluid flow-passages via the flow-passages 46A serving as third fluid flow-passages. The mixed fluid introduced into the flow-passages 40B flows from the right side toward the left side of the fluid flow-passage device 10 through the flow-passages 40B.

The mixed fluid flowing through the flow-passages 40B is introduced into the flow-passages 42B via the flow-passages 44A. The mixed fluid introduced into the flow-passages 42B flows from the left side toward the right side of the fluid flow-passage device 10 through the flow-passages 42B.

The mixed fluid flows through any of the plurality of flow-passages 42 when the mixed fluid flows from the left side toward the right side of the fluid flow-passage device 10, and flows through any of the plurality of flow-passages 40 when the mixed fluid flows from the right side toward the left side of the fluid flow-passage device 10 in this way. The mixed fluid flowing through any of the plurality of flow-passages 42 is introduced via the flow-passages 46 connected to the flow-passages 42 into any of the plurality of flow-passages 40 (specifically, the flow-passages 40 connected to the flow-passages 46). The mixed fluid flowing through any of the plurality of flow-passages 40 is introduced via the flow-passages 44 connected to the flow-passages 40 into any of the plurality of flow-passages 42 (specifically, the flow-passages 42 connected to the flow-passages 44).

The mixed fluid moves from the front side toward the rear side of the fluid flow-passage device 10 while moving in the left/right direction (from the right side to the left side or from the left side to the right side) of the fluid flow-passage device 10 in this way. Then, when the mixed fluid reaches a predetermined position, the mixed fluid is discharged to the outside of the fluid flow-passage device 10. A specific description will now be given.

As described above, the mixed fluid flowing through the flow-passages 42B is introduced via the flow-passages 46B, the flow-passage 40C, and the flow-passage 44B into the flow-passages 42C. The mixed fluid flowing through the flow-passages 42C is discharged via the hole 307 and the connector 37 to the outside of the fluid flow-passage device 10.

The fluid flow-passage device 10 includes the two flow-passages 12 for each one of process flow-passage units 20X. Each of the two flow-passages 12 includes the flow-passages through which the fluid is made to flow from the left side toward the right side of the fluid flow-passage device 10 (the plurality of flow-passages 40B and 40C shown in Fig. 7) and the flow-passages through which the fluid is made to flow from the right side toward the left side of the fluid flow-passage device 10 (the plurality of flow-passages 42A to 42C shown in Fig. 11) as shown in Fig. 23. The flow-passages through which the fluid is made to flow from the left side toward the right side of the fluid flow-passage device 10 (the plurality of flow-passages 40B and 40C shown in Fig. 7) and the flow-passages through which the fluid is made to flow from the right side toward the left side of the fluid flow-passage device 10 (the plurality of flow-passages 42A to 42C shown in Fig. 11) are formed at different positions in the lamination direction of the plurality of substrates 20A. That is, the two flow-passages 12 provided for the fluid flow-passage device 10 respectively have laminated structures. Therefore, the flow passage length of each of the two flow-passages 12 can be increased in the fluid flow-passage device 10.

The left ends of the plurality of flow-passages 40B and 40C are covered with the flange 30A, and the right ends of the plurality of flow-passages 40B and 40C are covered with the flange 30B in the fluid flow-passage device 10. In this configuration, the flange 30A and the flange 30B are respectively detachably attached to the body 20. Thus, an inside of each of the plurality of flow-passages 40B and 40C can easily be cleaned by inserting a cleaning device from the left end or the right end of each of the plurality of flow-passages 40B and 40C in the state in which the flange 30A and the flange 30B are detached from the body 20. A fluid for cleaning may be used for the cleaning of the inside of each of the plurality of flow-passages 40B and 40C.

The left ends of the plurality of flow-passages 42A to 42C are covered with the flange 30A, and the right ends of the plurality of flow-passages 42A to 42C are covered with the flange 30B in the fluid flow-passage device 10. In this state, the flange 30A and the flange 30B are respectively detachably attached to the body 20. Thus, an inside of each of the plurality of flow-passages 42A to 42C can easily be cleaned by inserting the cleaning device from the left end or the right end of each of the plurality of flow-passages 42A to 42C in the state in which the flange 30A and the flange 30B are detached from the body 20. The fluid for cleaning may be used for the cleaning of the inside of each of the plurality of flow-passages 42A to 42C.

Each of the plurality of flow-passages 40B and 40C shown in Fig. 7 linearly extends in the left/right direction of the body 20 in the fluid flow-passage device 10. Therefore, the cleaning the inside of each of the plurality of flow-passages 40B and 40C becomes easier.

Each of the plurality of flow-passages 42A to 42C shown in Fig. 11 linearly extends in the left/right direction of the body 20 in the fluid flow-passage device 10. Therefore, the cleaning the inside of each of the plurality of flow-passages 42A to 42C becomes easier.

The plurality of flow-passages 44 are formed by attaching the flange 30A to the left end surface 204 of the body 20 in the fluid flow-passage device 10. Therefore, the plurality of flow-passages 44 can easily be formed.

The groove 441 forming each of the plurality of flow-passages 44 is formed on the left end surface 204 of the body 20 in the fluid flow-passage device 10. Therefore, the grooves 441 can be cleaned by detaching the flange 30A.

The plurality of flow-passages 46 are formed by attaching the flange 30B to the right end surface 205 of the body 20 in the fluid flow-passage device 10. Therefore, the plurality of flow-passages 46 can easily be formed.

The groove 461 forming each of the plurality of flow-passages 46 is formed on the right end surface 205 of the body 20 in the fluid flow-passage device 10. Therefore, the grooves 461 can be cleaned by detaching the flange 30B.

The left end (upstream end) of the flow-passage 42 is at the positon different from the left end (downstream end) of the flow-passage 40 connected via the flow-passage 46 provided at the right end (downstream end) of the flow-passage 42 as viewed in the lamination direction of the plurality of substrates 20A in the fluid flow-passage device 10. Moreover, the right end (upstream end) of the flow-passage 40 is at the positon different from the right end (downstream end) of the flow-passage 42 connected via the flow-passage 44 provided at the left end (downstream end) of the flow-passage 42 as viewed in the lamination direction of the plurality of substrates 20A. Therefore, the flow-passages 40 and the flow-passages 42 can alternately be connected with each other. As a result, even if each of the plurality of flow-passages 40 and the plurality of the flow-passages 42 is in the shape linearly extending as viewed in the lamination direction of the plurality of substrates 20A, the flow passage length of each of the plurality of flow-passages 12 can be increased.

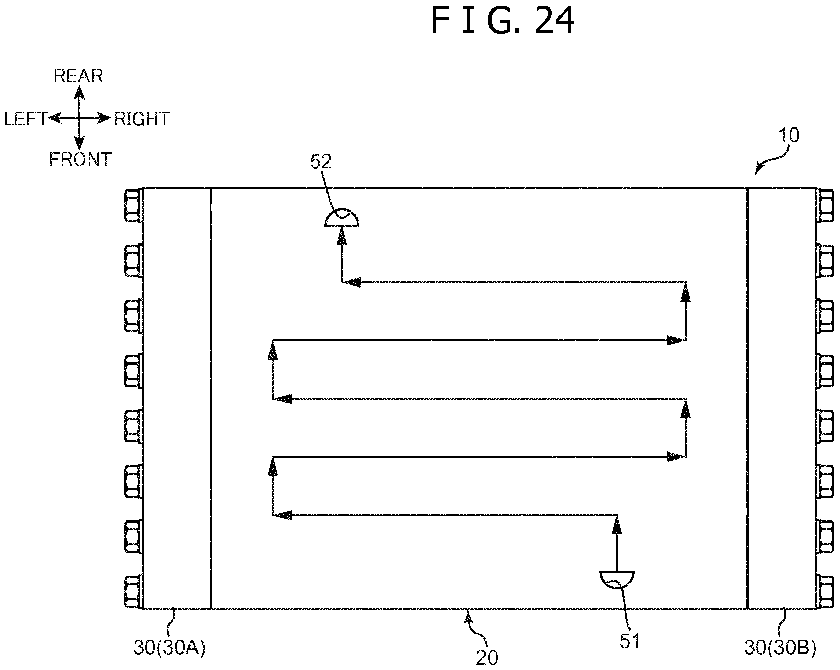

The fluid flow-passage device 10 is provided with the one flow-passage 50 for each of the temperature adjustment flow-passage units 20Y. The fluid flow-passage device 10 is provided with the two flow-passages 50 for each of the temperature adjustment flow-passage unit 20Z. The fluid is made to flow through the flow-passage 50 as shown in Fig. 24. The temperature of the fluid flowing through each of the two flow-passages 12 can be adjusted as the fluid flows through the flow-passage 50.

Although a detailed description has been given of the embodiment of the present invention, but the embodiment is only an example, and the embodiment can appropriately be modified and embodied without departing from the gist of the present invention.

Although the two flow-passages 12 are formed so as to extend in parallel to each other in the embodiment, three or more flow-passages 12 may be formed so as to extend in parallel to one another, for example.

Although each of the two flow-passages 12 is formed across the two layers in the embodiment, each of the two flow-passages 12 may be formed across three or more layers.

The numbers of the flow-passages 40, 42, 44, and 46 are not limited to the numbers described in the embodiment. The numbers of the flow-passages 40, 42, 44, and 46 are appropriately changed in accordance with the flow passage length of the flow-passages 12.

Although each of the plurality of flow-passages 40 and the plurality of flow-passages 42 opens on the left end surface 204 and the right end surface 205 of the body 20 in the embodiment, each of the plurality of flow-passages 40 and the plurality of flow-passages 42 may open on the front end surface 206 and the rear end surface 207 of the body 20, may open on the front end surface 206 and the left end surface 204 of the body 20, may open on the front end surface 206 and the right end surface 205 of the body 20, may open on the rear end surface 207 and the left end surface 204 of the body 20, or may open on the rear end surface 207 and the right end surface 205 of the body 20.

Although the fluid flow-passage device 10 is provided with three process flow-passage units 20X in the embodiment, the number of the process flow-passage units 20X provided for the fluid flow-passage device 10 may be one, two, or four or more, for example.

Although the connector 37 for discharging the mixed fluid is fixed to the flange 30 B in the state in which the connector 37 is inserted into the hole 307 in the embodiment, the connector 37 may be fixed to the flange 30B in a state in which the connector 37 is inserted into a hole 305 or the a hole 306, for example. The seal member 3122 is not necessary in the case in which the connector 37 is inserted into the hole 305 in this configuration. Similarly, the seal member 3123 is not necessary in the case in which the connector 37 is inserted into the hole 306.

Although the fluid flow-passage device 10 is provided with the two temperature adjustment flow-passage units 20Z in the embodiment, the two temperature adjustment flow-passage units 20Y may be employed in place of these two temperature adjustment flow-passage units 20Z.

Although the fluid flow-passage device 10 is provided with the two temperature adjustment flow-passage units 20Y in the embodiment, the two temperature adjustment flow-passage units 20Z may be employed in place of these two temperature adjustment flow-passage units 20Y.

Although the fluid flow-passage device 10 is provided with the two temperature adjustment flow-passage units 20Y and the two temperature adjustment flow-passage units 20Z in the embodiment, the fluid flow-passage device 10 may not be provided with these temperature adjustment flow-passage units 20Y and 20Z.

Although the flow-passage 50 is formed so as to meander as viewed in the lamination direction of the plurality of substrates 20A in the embodiment, the shape of the flow-passage 50 is not limited to the shape described in the embodiment.

Although the plurality of flow-passages 44 are formed between the left end surface 204 of the body 20 and the right surface 302 of the flange 30A in the embodiment, the plurality of flow-passages 44 may be flow-passages in a tunnel shape formed in the body 20 at positions separated from the left end surface 204 of the body 20.

Although the plurality of flow-passages 46 are formed between the right end surface 205 of the body 20 and the left surface 301 of the flange 30B in the embodiment, the plurality of flow-passages 46 may be flow-passages in a tunnel shape formed in the body 20 at positions separated from the right end surface 205 of the body 20.

Although a detailed description has been given of the embodiment of the present invention and variations thereof, they are only examples, and the present invention is not limited by the embodiment and the variations thereof in any way.

Applications of the fluid flow-passage device are not particularly limited in the present invention. The fluid flow-passage device may be used for a reactor or a heat exchanger, for example.

The fluid made to flow through each of the plurality of fluid flow-passages is not particularly limited in the present invention. The fluid made to flow through each of the plurality of fluid flow-passages may be a liquid, a gas, or a mixture of a fluid and a gas, for example.

The shape of the cross section (the cross section in the direction perpendicular to the direction in which the flow-passage extends) of each of the plurality of fluid flow-passages is not particularly limited in the present invention. The shape of the cross section of each of the plurality of fluid flow-passages may be, for example semicircular, circular, or polygonal. The circle includes not only a perfect circle, but also an ellipsoid in this configuration.

The shape of the cross section of each of the plurality of the fluid flow-passages may be constant or not constant in the direction in which each of the plurality of fluid flow-passages extends in the present invention.

The size of the cross section of each of the plurality of fluid flow-passages is not particularly limited in the present invention. The sizes of the respective cross sections of the plurality of fluid flow-passages may be the same as one another or may be different from one another. The size of the cross section of each of the plurality of fluid flow-passages is set in consideration of a resistance (flow resistance) when the fluid is made to flow through the fluid flow-passage, for example.

The size of the cross section of each of the plurality of the fluid flow-passages may be constant or may not be constant in the direction in which each of the plurality of fluid flow-passages extends in the present invention.

A shape (a shape as viewed in the lamination direction of the plurality of substrates) of each of the plurality of fluid flow-passages is not particularly limited in the present invention. The shape of each of the plurality of fluid flow-passages may be such that at least one of the first fluid flow-passage and the second fluid flow-passage has a shape that linearly extends, or at least one of the first fluid flow-passage and the second fluid flow-passage has a shape that curves or bends in the course, for example.

A direction in which the upstream end of the first fluid flow-passage opens may be the same as or different from a direction in which the downstream end of the first fluid flow-passage opens in the present invention. The direction in which the upstream end of the first fluid flow-passage opens may be opposite to the direction in which the downstream end of the first fluid flow-passage opens.

A direction in which the upstream end of the second fluid flow-passage opens may be the same as or different from a direction in which the downstream end of the second fluid flow-passage opens in the present invention. The direction in which the upstream end of the second fluid flow-passage opens may be opposite to the direction in which the downstream end of the second fluid flow-passage opens.

The shape of each of the plurality of substrates is not particularly limited in the present invention. Each of the plurality of the substrates only needs to have a flat surface in contact in the laminated state in the present invention. Each of the plurality of substrates may be in a rectangular plate shape, or in a circular plate shape, for example.

The shape of each of the plurality of lids is not particularly limited in the present invention. Each of the plurality of lids only needs to have a surface in contact with the body in the present invention. Each of the plurality of lids may be in a rectangular plate shape, for example.

A material of the substrate and the lid is not particularly limited in the present invention. The material of the substrate and the lid may be metal or ceramic, for example. The metal is, for example, stainless steel. The material of the substrate and the lid is set in consideration of corrosion resistance against the fluids made to flow in each of the plurality of fluid flow-passages, for example.

Each of the plurality of lids is attached to the side surface of the body in the present invention. The side surface of the body is realized by a side surface belonging to each of the laminated plurality of substrates.

The mode in which the first fluid flow-passage is formed between the two substrates includes a mode in which a groove formed on one substrate is covered with the other substrate, for example, in the present invention. A groove may be formed on the other substrate at a position corresponding to the groove formed on the one substrate. In the case in which the groove is formed on only one substrate, each of the upstream end and the downstream end of the first fluid flow-passage opens on the side surface of only the one substrate. In the case in which the groove is formed on each of the two substrates, each of the upstream end and the downstream end of the first fluid flow-passage opens on the side surface of each of the two substrates.

The mode in which the second fluid flow-passage is formed between the two substrates includes a mode in which a groove formed on one substrate is covered with the other substrate, for example, in the present invention. A groove may be formed on the other substrate at a position corresponding to the groove formed on the one substrate. In the case in which the groove is formed on only one substrate, each of the upstream end and the downstream end of the second fluid flow-passage opens on the side surface of only the one substrate. In the case in which the groove is formed on each of the two substrates, each of the upstream end and the downstream end of the second fluid flow-passage opens on the side surface of each of the two substrates.

Either one of the two substrates forming the second fluid flow-passage may be the same as either one of the two substrates forming the first fluid flow-passage in the present invention. In this case, out of the three laminated substrates, the first fluid flow-passage is formed between a first substrate and a second substrate, and the second fluid flow-passage is formed between the second substrate and a third substrate. Therefore, the number of the substrates forming the first fluid flow-passage and the second fluid flow-passage can be reduced.

The two substrates forming the second fluid flow-passage may be different from the two substrates forming the first fluid flow-passage in the present invention.

The third fluid flow-passage may not extend in parallel to the lamination direction of the plurality of substrates in the present invention. The third fluid flow-passage may extend in a direction inclined with respect to the lamination direction of the plurality of substrates, for example. That is, the downstream end of the first fluid flow-passage may be at a position different from the upstream end of the second fluid flow-passage as viewed in the lamination direction of the plurality of substrates.

The mode in which the third fluid flow-passage is formed between the body and the second lid includes a mode in which a groove formed on one of the body and the second lid is covered by the other one of them in the present invention. A groove may be formed on the other one of the body and the second lid at a position corresponding to the groove formed on the one of the body and the second lid in this case.

A hole for discharging the fluid made to flow through each of the plurality of fluid flow-passages to the outside of the fluid flow-passage device may be formed on any of the plurality of lids in the present invention. The number of the holes may be single or plural. If a plurality of holes are formed, the fluid is discharged to the outside of the fluid flow-passage device through any of the plurality of holes. A position of the hole is set in accordance with the flow passage length of each of the plurality of fluid flow-passages. That is, the hole for discharging the fluid is selected in accordance with a required flow passage length (a period required for the reaction of the fluids).

As described above, with the present invention, there is provided such a fluid flow-passage device that even if a plurality of fluid flow-passages are formed so as to extend in parallel to each other, the flow passage length of each of the plurality of fluid flow-passages can be increased, and the inside of each of the plurality of fluid flow-passages can easily be cleaned.

The present invention provides a fluid flow-passage device in which a plurality of fluid flow-passages which extend in parallel to each other and through each of which a fluid is made to flow are formed, including a body having a plurality of substrates that are laminated in a predetermined direction, a plurality of lids, each of which can be attached to and detached from the body, where each of the plurality of fluid flow-passages includes a first fluid flow-passage formed between two substrates in contact with each other in the lamination direction out of the plurality of substrates, a second fluid flow-passage formed between two substrates in contact with each other in the lamination direction out of the plurality of substrates, disposed at a position in the lamination direction different from that of the first fluid flow-passage, and positioned on a downstream side with respect to the first fluid flow-passage in the direction in which the fluid flows, and a third fluid flow-passage, which connects a downstream end of the first fluid flow-passage and an upstream end of the second fluid flow-passage with each other in the lamination direction, where the upstream end and the downstream end of the first fluid flow-passage open at least one of side surfaces respectively belonging to each of the two substrates forming the first fluid flow-passage out of the plurality of substrates, where the upstream end and the downstream end of the second fluid flow-passage open at least one of side surfaces respectively belonging to each of the two substrates forming the second fluid flow-passage out of the plurality of substrates, and where the plurality of lids include a first lid covering the upstream end of the first fluid flow-passage in a state in which the first lid is attached to the body, and a second lid covering the downstream end of the first fluid flow-passage and the upstream end of the second fluid flow-passage in a state in which the second lid is attached to the body.

The flow passage length of each of the plurality of fluid flow-passages can be increased in the fluid flow-passage device compared with a case in which a plurality of fluid flow-passages are formed so as to extend in parallel to each other on a certain plane. A reason for this will now be described.

Each of the plurality of fluid flow-passages includes first fluid flow-passages and the second fluid flow-passages in the fluid flow-passage device. The second fluid flow-passages are formed at the positions different from the positions of the first fluid flow-passages in the lamination direction of the plurality of substrates. That is, the plurality of fluid flow-passages are formed across the two layers. In other word, the plurality of fluid flow-passages have a hierarchical structure. As a result, the flow passage length of each of the plurality of fluid flow-passages can be increased compared with a case in which a plurality of fluid flow-passages are formed so as to extend in parallel to each other on a certain plane (that is, on one layer).

Moreover, the inside of each of the plurality of fluid flow-passages can easily be cleaned in the fluid flow-passage device. A reason for this will now be described.

The upstream end and the downstream end of the first fluid flow-passage open at least one of side surfaces respectively belonging to each of the two substrates forming the first fluid flow-passage in the fluid flow-passage device. The upstream end and the downstream end of the second fluid flow-passage open at least one of side surfaces respectively belonging to each of the two substrates forming the second fluid flow-passage.

The first lid covering the upstream ends of the first fluid flow-passages and the second lid covering the downstream ends of the first fluid flow-passages and the upstream ends of the second fluid flow-passages are respectively detachably attached to the body in this configuration.

Thus, each of the upstream ends and the downstream ends of the first fluid flow-passages can be opened by detaching the first lid and the second lid in the fluid flow-passage device. Therefore, a deposit and a foreign substance in the first fluid flow-passage can be removed by inserting a cleaning device into the first fluid flow-passage from at least one of the upstream end and the downstream end of the first fluid flow-passage, for example. Moreover, each of the upstream ends and the downstream ends of the second fluid flow-passages can be opened by detaching the second lid. Therefore, a deposit and a foreign substance in the second fluid flow-passage can be removed by inserting a cleaning device into the second fluid flow-passage from at least one of the upstream end and the downstream end of the second fluid flow-passage, for example.

That is, the inside of each of the plurality of fluid flow-passages can easily be cleaned in the fluid flow-passage device.

The third fluid flow-passage is preferably formed between the second lid and the body in the fluid flow-passage device.

In this case, the third fluid flow-passage can easily be cleaned by detaching the second lid from the body.

The third fluid flow-passage is preferably formed by the second lid covering the groove formed on the side surface of the body in the fluid flow-passage device.

In this case, the third fluid flow-passage can easily be cleaned by detaching the second lid from the body.

At least one of the first fluid flow-passage and the second fluid flow-passage preferably linearly extends from the upstream end toward the downstream end in the fluid flow-passage device.

In this case, the inside of the flow-passage linearly extending from the upstream end toward the downstream end out of the first fluid flow-passage and the second fluid flow-passage can easily be cleaned.

The downstream end of the second fluid flow-passage is formed at the position different from the upstream end of the first fluid flow-passage as viewed in the lamination direction in the fluid flow-passage device.

In this case, another flow-passage can easily be connected to the downstream end of the second fluid flow-passage. As a result, the flow passage length of each of the plurality of fluid flow-passages can further be increased.

The first lid preferably further covers the downstream end of the second fluid flow-passage in the fluid flow-passage device.

In this case, a lid for covering the downstream end of the second fluid flow-passage does not need to independently be provided. Therefore, the total number of the plurality of lids can be reduced.

## Claims

1. A fluid flow-passage device in which a plurality of fluid flow-passages which extend in parallel to each other and through each of which a fluid is made to flow are formed, comprising:
a body having a plurality of substrates laminated in a predetermined lamination direction; and
a plurality of lids, each of which can be attached to and detached from the body,
wherein each of the plurality of fluid flow-passages includes:
a first fluid flow-passage formed between two substrates in contact with each other in the lamination direction out of the plurality of substrates;
a second fluid flow-passage formed between two substrates in contact with each other in the lamination direction out of the plurality of substrates, disposed at a position in the lamination direction different from that of the first fluid flow-passage, and positioned on a downstream side with respect to the first fluid flow-passage in the direction in which the fluid flows; and
a third fluid flow-passage, which connects a downstream end of the first fluid flow-passage and an upstream end of the second fluid flow-passage with each other in the lamination direction,
wherein an upstream end and the downstream end of the first fluid flow-passage open at least one of side surfaces respectively belonging to each of the two substrates forming the first fluid flow-passage out of the plurality of substrates,
wherein the upstream end and the downstream end of the second fluid flow-passage open at least one of side surfaces respectively belonging to each of the two substrates forming the second fluid flow-passage out of the plurality of substrates, and
wherein the plurality of lids include:
a first lid covering the upstream end of the first fluid flow-passage in a state in which the first lid is attached to the body; and
a second lid covering the downstream end of the first fluid flow-passage and the upstream end of the second fluid flow-passage in a state in which the second lid is attached to the body.

2. The fluid flow-passage device according to claim 1, wherein the third fluid flow-passage is formed between the second lid and the body.

3. The fluid flow-passage device according to claim 2, wherein the third fluid flow-passage is formed by the second lid covering a groove formed on a side surface of the body.

4. The fluid flow-passage device according to any one of claims 1 to 3, wherein at least one of the first fluid flow-passage and the second fluid flow-passage linearly extends from the upstream end toward the downstream end.

5. The fluid flow-passage device according to any one of claims 1 to 3, wherein the downstream end of the second fluid flow-passage is formed at a position different from the upstream end of the first fluid flow-passage as viewed in the lamination direction.

6. The fluid flow-passage device according to any one of claims 1 to 3, wherein the first lid further covers the downstream end of the second fluid flow-passage.
